# EUROPÄISCHE PATENTSCHRIFT

(11) **EP 2 422 379 B1**
(45) Veröffentlichungstag und Bekanntmachung des Hinweises auf die Patenterteilung: **15.01.2014**
(21) Anmeldenummer: 10722548.4
(22) Anmeldetag: 20.04.2010
(51) Int. Cl.: H01L 41/09, H02N 2/04, H02N 2/12

(54) **ULTRASCHALLMOTOR**
ULTRASONIC MOTOR
MOTEUR À ULTRASONS

(30) Priorität: 21.04.2009 DE 102009018241; 03.09.2009 DE 102009039922
(43) Veröffentlichungstag der Anmeldung: 29.02.2012
(73) Patentinhaber: Physik Instrumente (PI) GmbH & Co. KG, 76228 Karlsruhe (DE)
(72) Erfinder: WISCHNEWSKIY, Wladimir, 77337 Waldbronn (DE); WISCHNEWSKIJ, Alexei, 76744 Wörth (DE)
(86) Internationale Anmeldenummer: PCT/DE2010/000444
(87) Internationale Veröffentlichungsnummer: WO 2010/121594

(56) Entgegenhaltungen:
- EP-A1- 0 790 481
- EP-A2- 1 267 425
- DE-A1-102006 041 017
- US-A- 5 216 313
- US-A1- 2002 057 038

## Beschreibung

Die Erfindung betrifft einen Ultraschallmotor, der zumindest einen Ultraschallaktor mit einer mittleren Länge L, einer Dicke B und einer mittleren Höhe H aufweist, und der wenigstens zwei an dem Ultraschallaktor angeordnete Friktionselemente umfasst, wobei die Friktionselemente zum Kontakt mit einem anzutreibenden Element vorgesehen sind, und der Ultraschallaktor wenigstens abschnittsweise als Ringsegment mit gekrümmten und/oder ebenen Seitenflächen und die Seitenflächen begrenzenden Oberflächen ausgeführt ist, und wobei der Ultraschallaktor Stirnflächen mit einer Breite C aufweist, an welchen die Friktionselemente angeordnet sind, und wobei der Ultraschallmotor weiterhin eine elektrische Erregervorrichtung umfasst

Die Erfindung gehört zur Gruppe der hochpräzisen Ultraschallmotoren und kann in sehr genauen Positionierungssystemen, beispielsweise zum Antrieb von exakt zu positionierenden Bearbeitungstischen, in optischen Präzisionssystemen und auch in Miniatureinrichtungen eingesetzt werden, bei denen niedrige Versorgungsspannungen verwendet werden.

Aus der DE 10 2004 024 656 A1 ist beispielsweise ein piezoelektrischer Ultraschallmotor bekannt, bei dem der Ultraschallaktor als piezoelektrische, rechteckförmige Platte mit zwei asymmetrischen Ultraschallwellengeneratoren ausgeführt ist. Dabei weist der Aktor an einer der langen Seitenflächen ein Friktionselement auf, wobei das Friktionselement im Wesentlichen mittig an der Seitenfläche angeordnet ist. Ein Nachteil dieses Motors besteht darin, dass es mittels des einen Friktionselements nicht im erforderlichen Umfang möglich ist, für den Aktor eine Last zu bilden. Dadurch verringert sich seine Effizienz und damit sein Wirkungsgrad. Überdies ist ein solcher Aktor mechanisch instabil, insbesondere bei großer Masse des anzutreibenden Elementes. Hierbei kann es vorkommen, dass der Motor beim Anlaufen bzw. Anhalten etwas durchdreht, was sofort zur Verringerung der Zug- bzw. Bremskraft des Motors führt. Beim Einsatz des Motors in hochpräzisen Positionierungssystemen führt dies zur Verschlechterung der Positioniergenauigkeit.

Aus der US 4 857 791 ist darüber hinaus ein Ultraschallmotor bekannt, bei dem der Ultraschallaktor als U-förmiger oder H-förmiger Metallresonator ausgeführt ist, der zwei Stößelelemente besitzt. Mit Hilfe des piezoelektrischen Erregers werden im Resonator dieses Motors Ultraschallschwingungen mit zwei verschiedenen Frequenzen erzeugt. Bei Erregung von Schwingungen einer Frequenz vollführt das eine Stößelelement eine Biegeschwingung, und bei Erregung einer Schwingung mit einer anderen Frequenz vollführt das andere Stößelelement eine Biegeschwingung. Dadurch bewegt sich der Motor in zwei verschiedenen Richtungen. Der Nachteil dieses Motors liegt darin, dass nur ein Stößelelement den Motor in Bewegung versetzt. Das zweite Stößelelement bremst den Motor. Dieses Wirkprinzip führt zu einer Erwärmung und zu einem erhöhten Verschleiß der Stößelelemente. In einem solchen Motor wird der Aktor ebenfalls nur durch ein Stößelelement belastet. Dies verschlechtert die Effizienz des Motors. Durch die Verwendung von Biegeschwingungen verringert sich die Zugkraft und es erhöht sich die Erregerspannung.

Zudem ist aus der US 5 134 334 ein Ultraschallmotor bekannt, bei dem der Ultraschallaktor als U-förmiger Metallresonator ausgeführt ist, mit dem zwei piezoelektrische Multilayererrreger verbunden sind. Der Aktor dieses Motors weist zwei gleichzeitig arbeitende Stößelelemente auf. Der Nachteil dieses Motors ist insbesondere darin zu sehen, dass es sehr schwierig ist, den piezoelektrischen Multilayererreger dauerhaft fest mit dem Metallresonator zu verbinden. Üblicherweise wird der piezoelektrische Erreger mit Epoxidkleber festgeklebt. Eine solche Klebeverbindung ist jedoch bedenklich, da bei hohen Erregerpegeln der Kleber aufgeweicht wird und sich der Erreger vom Resonator lösen kann. Dies führt zum Ausfall des Motors. Ferner ist bei einem solchen Motor das Volumen des Metallresonators um ein Vielfaches größer als das Volumen des piezoelektrischen Erregers. Dies erhöht sowohl die Erregerspannung, als auch die elektrischen Verluste im piezoelektrischen Multilayererreger. Dadurch erwärmt sich der Aktor schnell. Des Weiteren ist es unmöglich, für diesen Motor einen Aktor mit kleinen Abmessungen herzustellen, so dass ein entsprechender Motor zwangsläufig relativ große Abmessungen aufweist. Dies engt sein Einsatzgebiet deutlich ein. Da im Aktor gleichzeitig zwei Typen von Stehwellen erzeugt werden, ist es überdies unmöglich, auf einfache Weise seine Funktion in einem breiten Temperaturbereich zu stabilisieren. Dies erschwert die konstruktive Ausführung des elektrischen Aktors, was wiederum den Motor verteuert.

US 5 216 313 stellt einen Ultraschallmotor vor, des aus einem Ringsegment besteht.

Der Erfindung liegt daher die Aufgabe zugrunde, einen Ultraschallmotor bereit zu stellen, der die zuvor beschriebenen Nachteile der bekannten Ultraschallmotoren überwindet, und der insbesondere einen erhöhten Wirkungsgrad und eine erhöhte Betriebssicherheit bei gleichzeitig einfacher und Herstellungskosten senkender konstruktiver Ausführung aufweist.

Diese Aufgabe wird erfindungsgemäß dadurch gelöst, dass der Ultraschallaktor des eingangs erwähnten Ultraschallmotors einen Resonator einer asymmetrischen zweidimensionalen Stehwelle aufweist, wobei der Resonator einen ansteuerbaren Abschnitt und wenigstens zwei spiegelsymmetrisch zueinander angeordnete Stößelabschnitte aufweist, der ansteuerbare Abschnitt und die Stößelabschnitte einstückig miteinander ausgeführt sind, der Resonator zumindest einen Generator der asymmetrischen zweidimensionalen Stehwelle umfasst und das Verhältnis UH zwischen 1,5 und 3,5 liegt, und B zwischen H/2 und H/10, und C zwischen H/2 und H/5 liegt.

Die beiden Stößelabschnitte versetzen das anzutreibende Element gleichzeitig in Bewegung. Dadurch ist es möglich, den Aktor in ausreichendem Maße zu belasten, wodurch sich seine Effektivität und sein Wirkungsgrad erhöht. Daraus resultiert eine geringere Erwärmung des Motors. Da die Stößelabschnitte aktive Teile darstellen, treten ein geringerer Abrieb und eine geringere Erwärmung des Friktionskontaktes auf. Dies erhöht den Motorwirkungsgrad. Überdies wird zum Betrieb des Motors nur die Hälfte des aktiven Teils des Aktors verwendet. Dadurch wird die Erregerspannung abgesenkt und die Bewegungsgeschwindigkeit des anzutreibenden Elementes erhöht.

Der Aktor des erfindungsgemäßen Motors zeichnet sich durch eine hohe mechanische Stabilität aus. Dadurch ist es möglich, sowohl den Motor mit hoher Genauigkeit anzuhalten, als auch die Position des anzutreibenden Elementes mit hoher Präzision vorzugeben. Der Aktor des erfindungsgemäßen Motors stellt ein monolithisches oder einstückiges Element dar, was die Betriebssicherheit des Motors bei hohen Erregerspannungen des Aktors, d.h. bei hohen Bewegungsgeschwindigkeiten des anzutreibenden Elements, erhöht. Die konstruktive Auslegung des Aktors macht es möglich, seine Abmessungen und demzufolge die des Motors zu verringern. Die einfache Konstruktion des Aktors ermöglicht eine einfache Herstellungstechnologie und geringe Herstellungskosten für den Motor.

Die Begriffe ,Aktor' und ,Ultraschallaktor' werden in der vorliegenden Offenbarung synonym verwendet. Der Begriff ,Ring' bezeichnet nicht zwangsläufig ein exakt kreisförmiges, geschlossenes Element, sondern ein Element mit im Wesentlichen kreisförmiger und geschlossener Geometrie, d.h. dass ein solches Element beispielsweise auch Ecken bzw. Kanten aufweisen kann. Der Begriff ,Ringsegment' bezeichnet den aus dem zugrunde liegenden oder erzeugenden ,Ring' herausgearbeiteten oder heraus gelösten Teil.

Es kann günstig sein, dass der Ultraschallaktor als Segment eines im Wesentlichen runden oder elliptischen oder parabolischen Ringes ausgeführt ist. Zudem kann es günstig sein, dass der Ultraschallaktor als Segment eines eckigen, d.h. Ecken bzw. Kanten aufweisenden Ringes ausgeführt ist. Dies erweitert die konstruktiven Möglichkeiten zur Ausgestaltung des Ultraschallaktors. Hierbei kann es insbesondere günstig sein, dass der Ultraschallaktor zwei gekrümmte Seitenflächen aufweist, und die beiden gekrümmten Seitenflächen über die Stirnflächen und zwei ebene Seitenflächen miteinander verbunden sind.

Es kann von Vorteil sein, dass der Ultraschallmotor zwei sich kreuzende Ultraschallaktoren aufweist, wobei jeder der Ultraschallaktoren einen unabhängigen Resonator für eine asymmetrische zweidimensionale Ultraschallstehwelle bildet. Dies ermöglicht eine Zweikoordinatenbewegung bezüglich des anzutreibenden Elements, wobei sowohl eine Bewegung des anzutreibenden Elementes gegen den Ultraschallaktor als auch eine Bewegung des Ultraschallaktors gegen das anzutreibenden Element denkbar ist (Invertierung der Kinematik).

Weiterhin kann es von Vorteil sein, dass der Generator der asymmetrischen zweidimensionalen Stehwelle eine einschichtige oder mehrschichtige Piezokeramik aufweist. Bei einer einschichtigen Piezokeramik mit auf beiden Seiten der Piezokeramik angeordneten äußeren Elektroden ergibt sich ein besonders einfacher Aufbau, während bei Verwendung einer mehrschichtigen Keramik mit zwischen den Schichten angeordneten inneren Elektroden und zusätzlichen äußeren Elektroden, die der elektrischen Verbindung mit den inneren Elektroden dienen, die Amplitude der Erregerspannung des Ultraschallaktors deutlich reduziert werden kann.

Zudem kann es von Vorteil sein, dass die Friktionselemente eine ebene und/oder konvexe und/oder konkave und/oder gerippte Friktionsoberfläche aufweisen. Dies ermöglicht eine definierte und optimierte Anpassung der Friktionsoberfläche an die Oberfläche des anzutreibenden Elements. Insbesondere ermöglicht dies eine optimierte Anpassung hinsichtlich der Flächenpressung zwischen Friktionselement und anzutreibendem Element.

Außerdem kann es von Vorteil sein, dass das anzutreibende Element als Stab oder Platte oder Ring oder Scheibe, oder als Teil eines Rings oder als Teil einer Scheibe ausgeführt ist und jeweils einen einschichtigen oder mehrschichtigen Aufbau aufweist. Dies ermöglicht eine für den jeweiligen Anwendungsfall optimierte Geometrie des anzutreibenden Elements. Besonders vorteilhaft kann es hierbei sein, dass das anzutreibende Element als Scheibe ausgeführt ist und durch ein Lagerelement, vorzugsweise durch ein Rollenlager, gelagert ist.

Ebenso kann es von Vorteil sein, dass das anzutreibende Element durch gegenüberliegend oder versetzt zueinander angeordnete Ultraschallaktoren gehalten wird. Darüber hinaus kann von Vorteil sein, dass das anzutreibende Element durch wenigstens ein auf zumindest einer der Oberflächen des Ultraschallaktors angeordnetes elastisches Element, vorzugsweise durch ein Federelement, gehalten wird. Beide zuvor genannten vorteilhaften Ausführungsformen erweitern die konstruktiven Gestaltungsmöglichkeiten des erfindungsgemäßen Ultraschallmotors.

Es kann vorteilhaft sein, dass die elektrische Erregervorrichtung einen Erzeuger einer elektrischen Wechselspannung umfasst, und der Erzeuger aus einem Leistungsverstärker, einer Formierungseinrichtung des Erregersignals und einem Rückkopplungskreis besteht, die einen geschlossenen Kreis bilden, der die Frequenz der elektrischen Spannung des angesteuerten Aktors gleich oder nahe zur Resonanzfrequenz der im Aktor erzeugten asymmetrischen zweidimensionalen Ultraschallstehwelle hält. Dies erhöht die Betriebsstabilität des Motors.

Es kann auch vorteilhaft sein, dass die elektrische Erregervorrichtung eine Amplitudennachstimmeinrichtung des angeregten Ultraschallaktors aufweist. Dadurch läst sich der Motor mit hoher Genauigkeit steuern.

Ebenso kann es vorteilhaft sein, dass die Amplitudennachstimmeinrichtung als analoger Leistungsverstärker ausgeführt ist. Dies vereinfacht den Motor.

Zudem kann es vorteilhaft sein, dass die Amplitudennachstimmeinrichtung als PWM-Controler ausgeführt ist. Die Abkürzung ,PWM' steht hierbei für Pulse Width Modulation oder Pulsweiternmodulation. Die Ausführung der Amplitudennachstimmeinrichtung als PWM-Controler erhöht die Motorleistung.

Es kann sich als günstig erweisen, dass der Leistungsverstärker der elektrischen Erregervor richtung des Ultraschallaktors als Linearverstärker und die Amplitudennachstimmeinrichtung als programmierbarer Synthesizer einer sinusförmigen oder quasisinusförmigen elektrischen Spannung ausgeführt ist. Außerdem kann es sich als günstig erweisen, dass der Leistungsverstärker der elektrischen Erregervorrichtung des Ultraschallaktors als D-Leistungsverstärker und die Amplitudennachstimmeinrichtung als PWM-Modulalator ausgeführt ist. Darüber hinaus kann es sich als günstig erweisen, dass der Leistungsverstärker der elektrischen Erregervorrichtung des Ultraschallaktors als D-Leistungsverstärker und die Amplitudennachstimmeinrichtung als Sigma-Delta-Modulator ausgeführt ist. Jede der zuvor genannten vorteilhaften Ausführungsform erweitert die konstruktiven Gestaltungsmöglichkeiten für die elektrische Erregervorrichtung.

Es kann von Vorteil sein, dass das anzutreibende Element mit einem Lagegeber und die elektrische Erregervorrichtung mit einer prozessorgeführten Nachstimmeinrichtung für die vorgegebene Lage oder die Bewegungsgeschwindigkeit des anzutreibenden Elements versehen ist.

Selbstverständlich ist es denkbar, die zuvor erwähnten vorteilhaften Ausführungsformen der Erfindung miteinander zu kombinieren, wobei auch eine Kombination nur einzelner Merkmale der verschiedenen vorteilhaften Ausführungsformen möglich ist.

Die bevorzugten Ausführungsbeispiele und Anwendungen der Erfindung werden nachstehend mit Bezug auf die beiliegenden Zeichnungen im Detail beschrieben. Es zeigen - jeweils in schematischer und nicht maßstabsgetreuer Weise -
- Figur 1: Perspektivische Darstellung eines erfindungsgemäßen Ultraschallmotors zusammen mit einem anzutreibenden Element
- Figur 2: Position 6: Darstellung zur Erläuterung der Bildung des Ultraschallaktors eines erfindungsgemäßen Ultraschallmotors; Position 12: Darstellung des aus dem zugrunde liegenden oder erzeugenden Ring gemäß Position 6 herausgearbeiteten Ultraschallaktors
- Figur 3: Position 14: Draufsicht auf einen Ultraschallaktor eines erfindungsgemäßen Ultraschallmotors; Position 16: Seitenansicht des Ultraschallaktors gemäß Position 14; Position 20: Schnittdarstellung des Ultraschallaktors gemäß Position 14.
- Figur 4: Positionen 25-32: Darstellungen möglicher Geometrien des Ultraschallaktors eines erfindungsgemäßen Ultraschallmotors
- Figur 5: Position 34: Draufsicht auf einen Ultraschallaktor eines erfindungsgemäßen Ultraschallmotors; Position 37: perspektivische Darstellung des Ultraschallaktors gemäß Position 34
- Figur 6: Darstellung des inneren Aufbaus des Ultraschallaktors eines erfindungsgemäßen Ultraschallmotors mit einer Multilayerstruktur
- Figur 7: Positionen 44-50: Darstellungen möglicher Geometrien der Friktionselemente
- Figur 8: Positionen 52-59: Darstellung möglicher stabförmiger Geometrien des anzutreibenden Elements
- Figur 9: Positionen 60-66: Darstellung möglicher scheibenförmiger bzw. ringförmiger Geometrien des anzutreibenden Elements
- Figur 10: Darstellung eines Ultraschallaktors zusammen mit einem anzutreibenden Element
- Figur 11: Darstellung einer Ausführungsform des erfindungsgemäßen Ultraschallmotors
- Figur 12: Darstellung einer weiteren Ausführungsform des erfindungsgemäßen Ultraschallmotors
- Figur 13: Darstellung einer Ausführungsform des erfindungsgemäßen Ultraschallmotors mit zwei gegenüberliegend angeordneten Ultraschallaktoren und einem ebenen anzutreibenden Element
- Figur 14: Darstellung einer Ausführungsform des erfindungsgemäßen Ultraschallmotors mit zwei gegenüberliegend angeordneten Ultraschallaktoren und einem rundstabförmigen anzutreibenden Element
- Figur 15: Darstellung einer Ausführungsform des erfindungsgemäßen Ultraschallmotors mit mehreren versetz zueinander angeordneten Ultraschallaktoren
- Figur 16: Darstellung einer Ausführungsform des erfindungsgemäßen Ultraschallmotors, wobei der Ultraschallaktor mittels Federelementen an ein rundstabförmiges anzutreibendes Element angedrückt ist
- Figur 17: Darstellung einer Ausführungsform des erfindungsgemäßen Ultraschallmotors mit einem scheibenförmigen anzutreibenden Element
- Figur 18: Darstellung einer Ausführungsform des erfindungsgemäßen Ultraschallmotors mit zwei gegenüberliegend angeordneten Ultraschallaktoren und einem ringförmigen anzutreibenden Element
- Figur 19: Darstellung einer weiteren Ausführungsform des erfindungsgemäßen Ultraschallmotors mit zwei gegenüberliegend angeordneten Ultraschallaktoren und einem ringförmigen anzutreibenden Element
- Figur 20: Position 76: Darstellung einer Ausführungsform des Ultraschallaktors eines erfindungsgemäßen Ultraschallmotors mit vier Stößelabschnitten; Position 80: Darstellung des Ultraschallaktors gemäß Position 76 zusammen mit zwei anzutreibenden Elementen
- Figur 21: Position 81: Perspektivische Darstellung eines erfindungsgemäßen Ultraschallmotors mit zwei sich kreuzenden Ultraschallaktoren; Position 83: Draufsicht auf den Ultraschallmotor gemäß Position 81
- Figur 22: Darstellung der Antriebsmöglichkeit des Ultraschallmotors gemäß Figur 21
- Figur 23: Ultraschallmotor gemäß Figur 21 zusammen mit einem kugelförmigen anzutreibenden Element
- Figur 24: Blockschaltbild einer elektrischen Erregervorrichtung für einen erfindungsgemäßen Ultraschallmotor
- Figur 25: Blockschaltbild einer elektrischen Erregervorrichtung für einen weiteren erfindungsgemäßen Ultraschallmotor mit sich kreuzenden Ultraschallaktoren
- Figur 26: Position 93: Frequenzabhängigkeit der Impedanz Z des Ultraschallaktors gemäß Position 94; Position 94: mögliche Ausführungsform des Ultraschallaktors des erfindungsgemäßen Ultraschallmotors
- Figur 27: Position 95: Computersimulation einer Phase mit maximaler Deformation des Ultraschallaktors eines erfindungsgemäßen Ultraschallmotors; Position 96: Computersimulation einer zweiten Phase mit maximaler Deformation des Ultraschallaktors eines erfindungsgemäßen Ultraschallmotors
- Figur 28: Positionen 97 und 98: Schematische Darstellung eines Ultraschallaktors in den Momenten seiner maximalen Deformation; Position 102: Darstellung der Verschiebungsrichtung von Materialpunkten des Ultraschallaktors
- Figur 29: Blockschaltbild einer elektrischen Erregervorrichtung für einen erfindungsgemäßen Ultraschallmotor
- Figur 30: Blockschaltbild einer elektrischen Erregervorrichtung für einen weiteren erfindungsgemäßen Ultraschallmotor mit sich kreuzenden Ultraschallaktoren
- Figur 31: Blockschaltbild einer weiteren elektrischen Erregervorrichtung für einen erfindungsgemäßen Ultraschallmotor
- Figur 32: Blockschaltbild einer weiteren elektrischen Erregervorrichtung für einen erfindungsgemäßen Ultraschallmotor
- Figur 33: Blockschaltbild einer weiteren elektrischen Erregervorrichtung für einen erfindungsgemäßen Ültraschallmotor
- Figur 34: Blockschaltbild einer weiteren elektrischen Erregervorrichtung für einen erfindungsgemäßen Ultraschallmotor
- Figur 35: Blockschaltbild einer weiteren elektrischen Erregervorrichtung für einen erfindungsgemäßen Ultraschallmotor
- Figur 36: Blockschaltbild einer weiteren elektrischen Erregervorrichtung für einen erfindungsgemäßen Ultraschallmotor
- Figur 37: Blockschaltbild zur Erläuterung einer möglichen Ansteuerung eines erfindungsgemäβen Ultraschallmotors

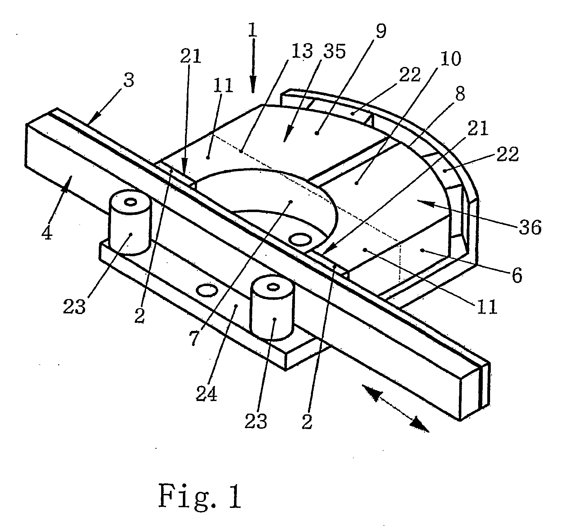

Figur 1 zeigt in schematischer und perspektivischer Weise einen erfindungsgemäßen Ultraschallmotor zusammen mit einem anzutreibenden Element. Der Ultraschallmotor weist einen Ultraschallaktor 1 mit zwei an dessen ebenen Stirnflächen 21 angeordneten Friktionselementen 2 auf, die mittels elastischer Elemente 22 an die Friktionsschicht 3 des anzutreibenden Elements 4 angepresst sind. Die elastischen Elemente bestehen beispielsweise aus einem gummielastischen Werkstoff. Der Ultraschallaktor 1 besteht aus Piezokeramik und seine Geometrie stellt einen Abschnitt eines zugrunde liegenden, erzeugenden Ringes dar. Der Ultraschallaktor weist hierbei eine innere gekrümmte Seitenfläche 7 und eine äußere gekrümmte Seitenfläche 8 auf, wobei die inneren und äußeren gekrümmten Seitenflächen 7 und 8 über die ebenen Seitenflächen 6 miteinander verbunden sind. Der Ultraschallaktor 1 umfasst weiterhin einen elektrisch ansteuerbaren Abschnitt 10 und zwei Stößelabschnitte 11. Der ansteuerbare Abschnitt 10 und die Stößelabschnitte 11 sind in Figur 1 durch eine gestrichelte Linie 13 voneinander getrennt. Die Stößelabschnitte 11 sind spiegelsymmetrisch zueinander angeordnet. Das anzutreibende Element 4 ist durch ein Paar von Rollen 23 gelagert, die an einem Gehäuse 24 angeordnet sind. An dem Gehäuse 24 stützen sich ebenso die elastischen Elemente 22 ab.

Im Ultraschallaktor 1 des erfindungsgemäßen Ultraschallmotors bilden der ansteuerbare Abschnitt 10 und die zwei Stößelabschnitte 11 einen Resonator für eine zweidimensionale asymmetrische Ultraschallstehwelle, wobei der ansteuerbare Abschnitt 10 die zwei spiegelsymmetrisch angeordneten Generatoren 35 und 36 aufweist, d.h. jeder Generator bildet den jeweils anderen spiegelbildlich ab.

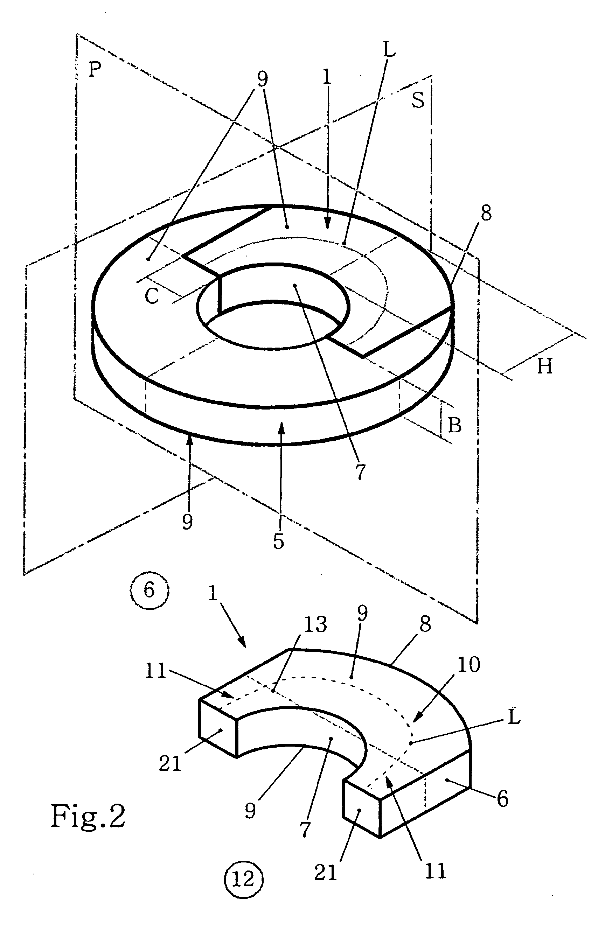

Figur 2 zeigt in Position 6 eine Erläuterung zur Bildung bzw. Formung der Geometrie des Ultraschallaktors 1 des erfindungsgemäßen Ultraschallmotors. Hierbei ist der Ultraschallaktor Teil bzw. Abschnitt eines entsprechenden erzeugenden Ringes, aus welchem er herausgearbeitet wurde. Der Ultraschallaktor weist hierbei eine Dicke B auf, die dem Abstand der gegenüberliegenden Flächen 9 entspricht. Die Stirnflächen 21 des Ultraschallaktors besitzen die Breite C. Weiterhin besitzt der Ultraschallaktor die mittlere Länge L, wobei die mittlere Länge L die Länge der Linie ist, die durch eine der Oberflächen 9 im gleichen Abstand zu den jeweiligen in radialer Richtung gegenüberliegenden Seitenflächen 6, 7 und 8 verläuft. Das bedeutet, dass alle Punkte dieser Linie am jeweiligen Ort zu den entsprechenden Seitenflächen 6, 7 und 8 in radialer Richtung den gleichen bzw. identischen Abstand aufweisen. Zudem weist der Ultraschallaktor die mittlere Höhe H auf, welche der Höhe des Aktors entspricht, die dieser entlang der Symmetrieebene S besitzt. Also handelt es sich bei der mittleren Höhe um die radiale Ausdehnung des Ultraschallaktors entlang der Symmetrieebene S. Position 12 der Figur 2 zeigt den Ultraschallaktor als entsprechend herausgearbeiteten Teil oder Abschnitt dieses Ringes.

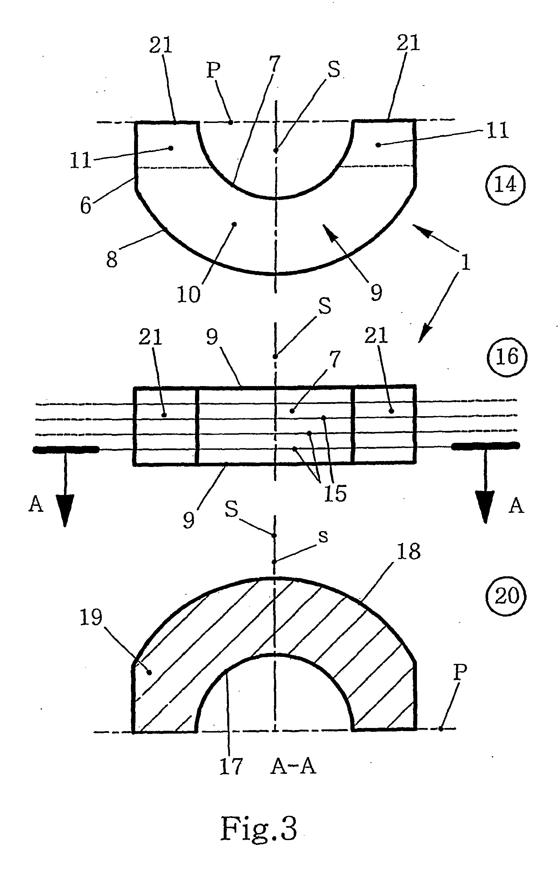

Gemäß Position 14 der Figur 3 ist der Ultraschallaktor auf einer Seite begrenzt durch die Ebene P, welche mit den Stirnflächen 21 des Ultraschallaktors zusammenfällt. Besagte Ebene P verläuft senkrecht zu den ebenen Oberflächen 9 des Ringes 5 bzw. des Ultraschallaktors 1. Senkrecht zur Ebene P verläuft die Symmetrieebene S, welche mit einem Durchmesser des erzeugenden Rings 5 zusammenfällt. In der Seitenansicht gemäß Position 16 sind einzelne Schnittebenen 15, die parallel zu den Oberflächen 9 des Ultraschallaktors verlaufen, eingezeichnet. Eine entsprechende Schnittansicht zeigt Position 20:

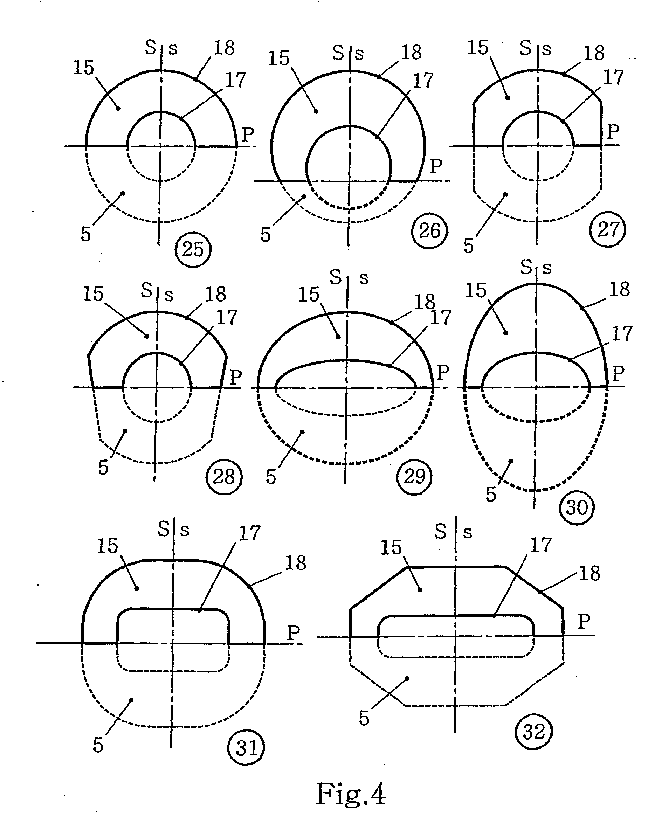

Figur 4 zeigt mit den Positionen 25 bis 32 einige der möglichen Geometrien des Ultraschallaktors eines erfindungsgemäßen Ultraschallmotors, jeweils bezogen auf eine Schnittebene 15, auf. Die Formen des Aktors 1 und des ihm zugrunde liegenden erzeugenden Ringes 5 unter scheiden sich voneinander durch die Form und die gegenseitige Lage der bezogen auf die Symmetrieebene S bzw. auf die mit der Symmetrieebene zusammenfallende Symmetrieachse s achssymmetrisch verlaufende Linien 17 und 18, und der Anordnung der Schnittebene P. Die Linien 17, 18 können eine runde Form (Positionen 25 und 26) mit zusammenfallenden und nicht zusammenfallenden Zentren, bzw. eine elliptische, eine parabolische oder eine ovale Form (Positionen 29 und 30), oder eine aus geraden Linien oder einer Kombination gekrümmter Linien mit geraden Linien (Positionen 27, 28, 31 und 32) gebildete Form haben.

Während in den Positionen 25, 27 und 29-32 die Ultraschallaktoren eine Spiegelsymmetrie bezüglich der Ebene P aufweisen, ist dies bei den Ultraschallaktoren gemäß den Positionen 26 und 28 nicht der Fall. Immer jedoch sind die Ultraschallaktoren als Teil oder Abschnitt eines zugrunde liegenden, erzeugenden Ringes aufzufassen.

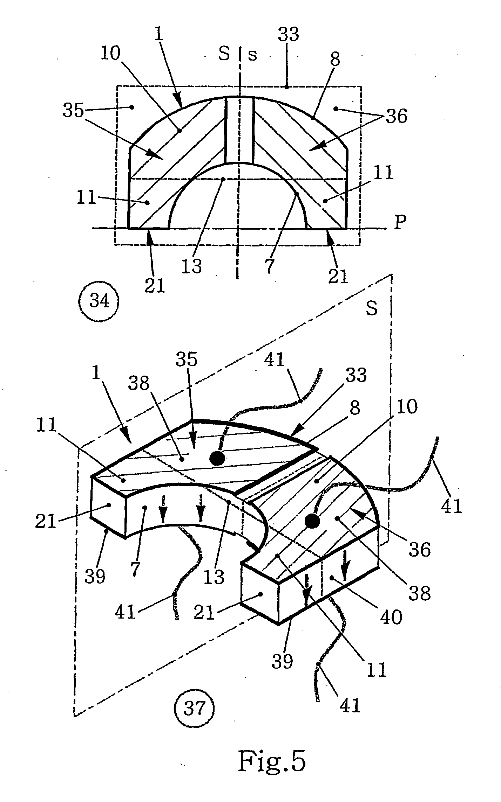

Gemäß der Position 37 von Figur 5 kann jeder der Generatoren 35 und 36 eine einschichtig ausgeführte Piezokeramik aufweisen, wobei eine Piezokeramikschicht 40 zwischen einer Erregerelektrode 38 und einer allgemeinen Elektrode 39 angeordnet ist. Hierbei ist die Piezokeramik normal zu den Elektroden 38 und 39 polarisiert, wobei die Polarisationsrichtung in unterschiedlichen Bereichen verschieden sein kann (antiparallele Polarisationsrichtungen). Die Polarisationsrichtung ist in Position 37 der Figur 5 mit Pfeilen gekennzeichnet. Zudem zeigt Position 37 von Figur 5 elektrische Anschlüsse 41, über welche die Elektroden 38 und 39 mit Spannung versorgt werden.

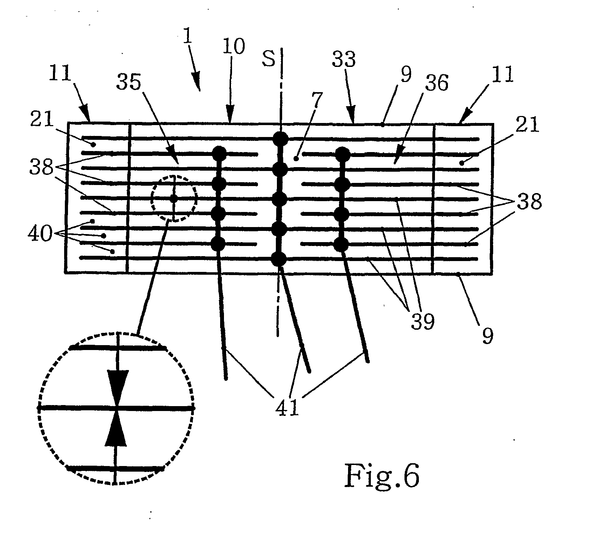

Figur 6 zeigt eine mögliche Ausführungsform der Generatoren 35 und 36, bei welcher diese eine Multilayerstruktur mit sich abwechselnden Schichten der Erregerelektroden 38, der allgemeinen Elektroden 39 und der piezoelektrischen Keramikschichten 40 zwischen ihnen aufweisen. Wiederum ist die Piezokeramik bzw. sind die Piezokeramikschichten 40 normal zu den Elektroden 38 und 39 polarisiert.

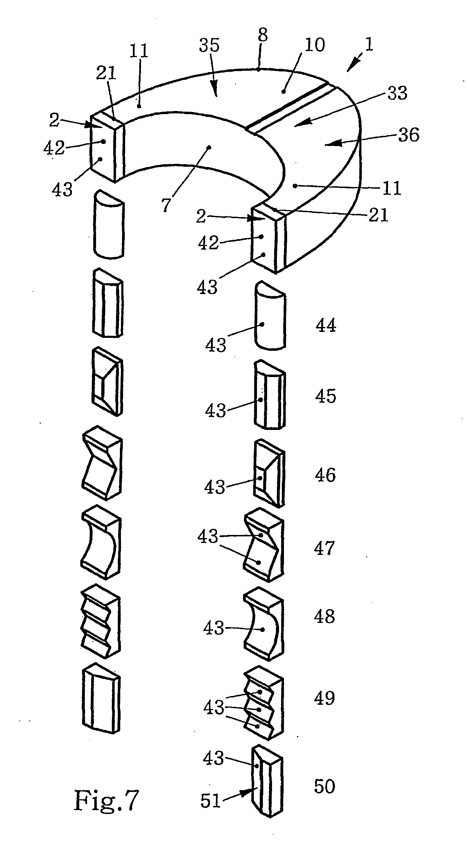

Figur 7 zeigt einen Ultraschallaktor eines erfindungsgemäßen Ultraschallmotors und in den Positionen 44 bis 50 zusätzlich einige der möglichen Ausführungsformen für die Friktionselemente 2. Die Friktionselemente 2 können als dünne Schichten oder dünne Platten 42 mit einer ebenen Friktionsoberfläche 43 ausgeführt werden. Außerdem können sie die Form von Prismen (Positionen 44 bis 50) haben, die eine konvexe, eine konkave oder eine gerippte Form der Friktionsoberfläche 43 aufweisen. Zur Kontaktierung der Friktionselemente 2 mit einem als Drehkörper ausgeführten anzutreibenden Element können sie Fasen 51 aufweisen, wie dies in Position 50 von Figur 7 dargestellt ist.

Die als dünne Schichten 42 ausgeführten Friktionselemente 2 eines abriebfesten Werkstoffs können aus harten Glassorten oder aus Glas, angefüllt mit harten Teilchen abriebfesten Materials und ausgerichtet auf die Oberfläche der Piezokeramik, hergestellt sein.

Die dünnen Friktionsschichten 42 können mit Hilfe von Plasmaverfahren als dünne Aluminiumoxidschichten oder als Schichten eines anderen harten abriebfesten Materials aufgetragen sein. Weiterhin kann eine Schicht verwendet werden, die kleine, aus der Gasphase ausgeschiedene Diamantenkristalle oder eine Schicht in Form dünner Beläge aus CrN, CrCN, (Cr,W)N, (Cr,Al)N, NbN-CrN, TiN, TiCN, (Ti,Al)N, V₂O₅ und ähnlichen Verbindungen enthält. Die dünnen Friktionsschichten 42 können zudem als chemische oder elektrochemische Ausscheidung von Nickel oder in Form einer Schicht von Hartchrom u. ä. aufgetragen sein. Die dünnen Friktionsschichten können außerdem eine Unterschicht aus einem harten Material, wie z. B. Oxidkeramik oder eine andere Keramik, aufweisen.

Die als dünne Beläge 42 oder als Prismen gemäß den Positionen 44 bis 50 der Figur 7 ausgeführten Friktionselemente 2 können aus harter abriebfester Oxidkeramik auf der Basis von Al₂O₃, ZrO₂, SiC, Si₃N₄ oder anderen Oxidkeramiken hergestellt sein. Die Friktionselemente können ebenso aus harten Monokristallen wie z. B. Saphir, Rubin oder Korund gefertigt sein. Sie können auch aus Metallkeramik hergestellt sein. Ferner können die Friktionselemente auf der Basis von Verbindungen wie Wolframkarbid, Titankarbid u. ä. gefertigt sein. Außerdem können die Friktionselemente aus harten Sorten von Plastwerkstoffen, angereichert mit Teilchen eines harten abriebfesten Materials, wie z. B. Aluminiumoxid, Zirkoniumoxid, Glas, Wolframkarbid, Titankarbid u. ä., hergestellt sein.

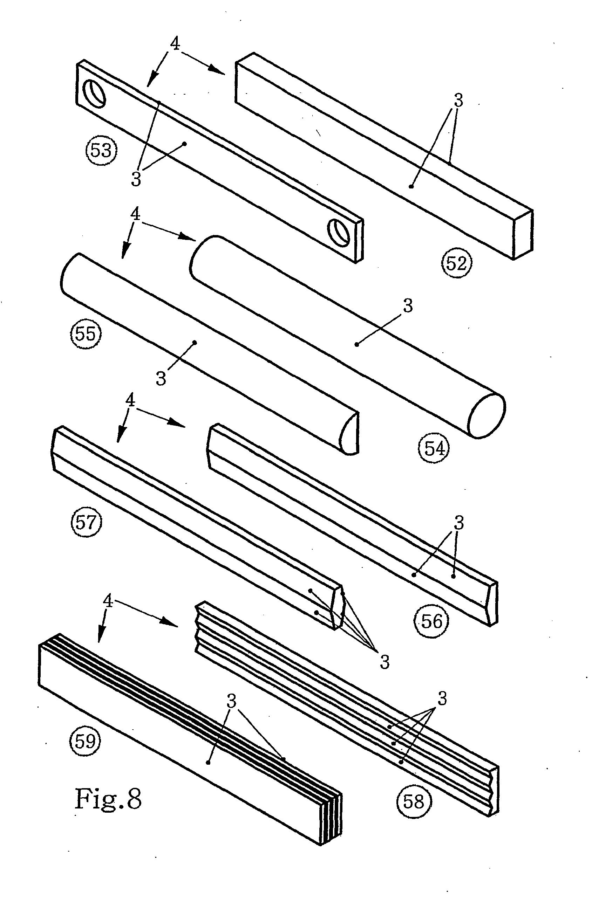

Die Positionen 52 bis 58 von Figur 8 zeigen mögliche Ausführungsformen des anzutreibenden Elements 4, jeweils ausgeführt als monolithischer Stab oder als monolithische Platte. Auf dem anzutreibenden Element 4 können sich eine oder aber auch mehrere Friktionsschichten 3 befinden. Zusätzlich kann das als Stab ausgeführte anzutreibende Element über eine Multilayerstruktur verfügen, wie dies in Position 59 der Figur 8 gezeigt ist.

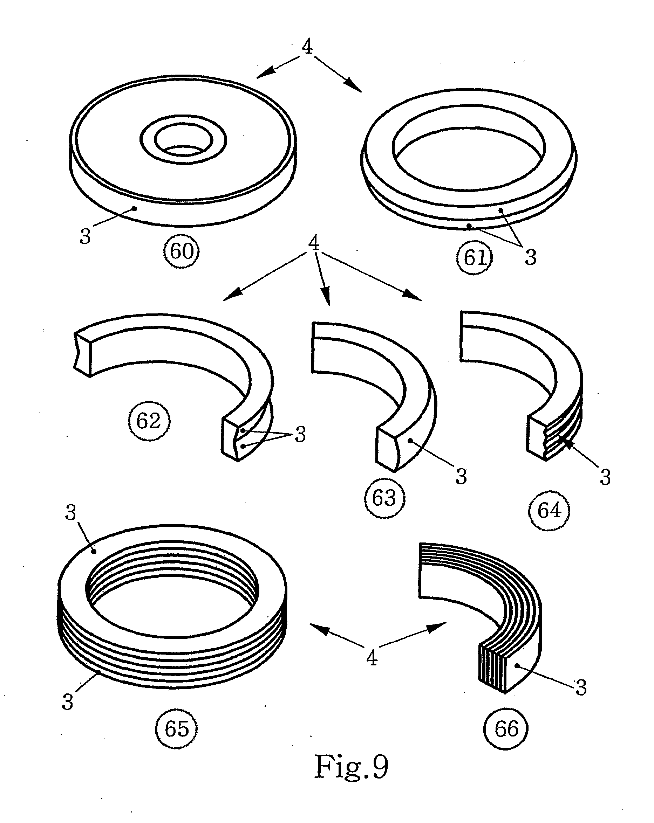

Figur 9 zeigt in den Positionen 60 und 61 als monolithische, ring- oder scheibenförmige Drehkörper ausgeführte anzutreibende Elemente 4. Gemäß den Positionen 62 bis 64 von Figur 9 ist das anzutreibende Element als Teil oder Abschnitt eines monolithischen und ringförmigen Drehkörpers ausgebildet. Nach Position 65 der Figur 9 ist es auch möglich, das anzutreibende Element 4 als ringförmigen Multilayer-Drehkörper auszuführen. Zudem ergibt sich aus Position 66 der Figur 9, dass das anzutreibende Element 4 auch als Teil oder Abschnitt eines ringförmigen Multilayer-Drehkörpers ausgeführt sein kann.

Die monolithisch ausgeführten anzutreibenden Elemente 4 gemäß den Positionen 60 bis 64 können aus harter abriebfester Oxidkeramik auf der Basis von Al₂O₃, ZrO₂, SiC, Si₃N₄ oder anderen Nichtoxidkeramiken oder Metallen hergestellt sein. Als Friktionselementsschichten kann die Oberfläche der Oxidkeramik dienen. Auf die Nicht-Oxidkeramik oder auf diese Metalle kann ein harter abriebfester Belag, in Analogie wie dies für den dünnen Friktionsbelag 43 des Friktionselementes 2 erfolgte, aufgetragen sein.

Die anzutreibenden Elemente 4 mit Multilayerstruktur bestehen aus abwechselnd angeordneten Schichten mit jeweils unterschiedlichem Elastizitätsmodul und unterschiedlicher Härte. Die Außenschicht bildet der Friktionsbelag 3.

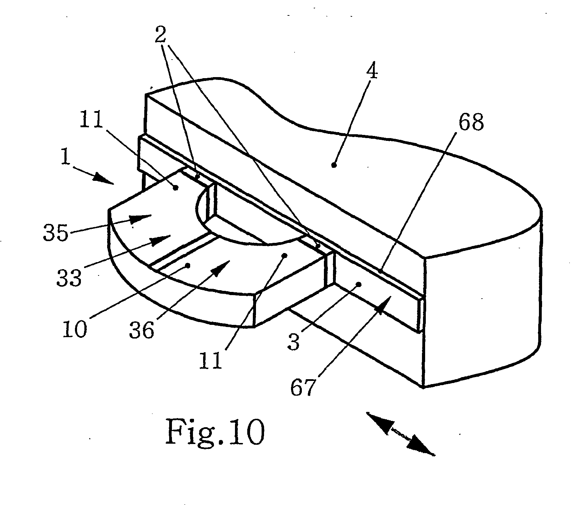

Im erfindungsgemäßen Ultraschallmotor kann das anzutreibende Element 4 eine beliebige Form aufweisen, wie dies in Figur 10 dargestellt ist. Es kann aus einem harten Material wie Stahl oder einem weichen Material wie z. B. Aluminium oder Plastwerkstoff hergestellt sein. Zur Verhinderung von akustischen Erregungen kann der Körper des anzutreibenden Elementes mit einer Schiene 67 mit dem Friktionsbelag 3, die über die schallisolierende Schicht 68 mit dem anzutreibenden Element 4 verbunden ist, versehen sein. Als eine solche Schicht kann ein Weichkleber, eine Schicht aus Gummi oder eine schallabsorbierende Schicht aus Plastwerkstoff o. ä. verwendet werden.

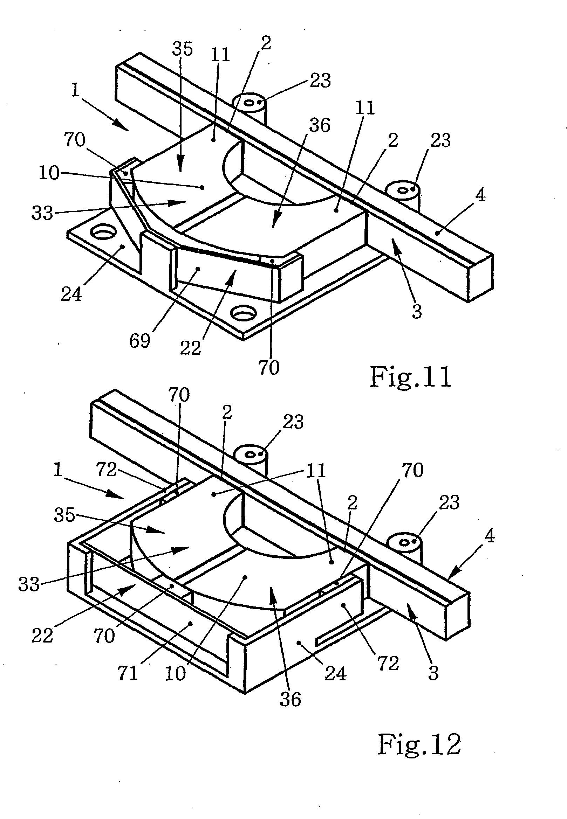

Die Figuren 11 bis 18 zeigen unterschiedliche Ausführungsformen des erfindungsgemäßen Ultraschallmotors in verschiedenen Anwendungsbeispielen. In dem in Figur 11 dargestellten Motor wird der Aktor 1 mit Hilfe des als im Wesentlichen U-förmige Feder ausgebildeten elastischen Elements 22 an das anzutreibende Element gepresst, wobei die im Wesentlichen U-förmige Feder gleichzeitig den Aktor 1 über die schallisolierende Zwischenschicht 70 festhält. Die schallisolierende Zwischenschicht 70 kann sowohl aus Gummi, als auch aus Plastwerkstoff hergestellt sein.

In dem in Figur 12 dargestellten Ultraschallmotor wird der Aktor 1 mit Hilfe der Flachfeder 71 an das anzutreibende Element 4 angepresst und mit Hilfe von zwei Resonanzhaltern 72, die Teil des Gehäuses 24 sind, fixiert. Ebenso ist es hierbei möglich, nur einen Resonanzhalter 72 zu verwenden.

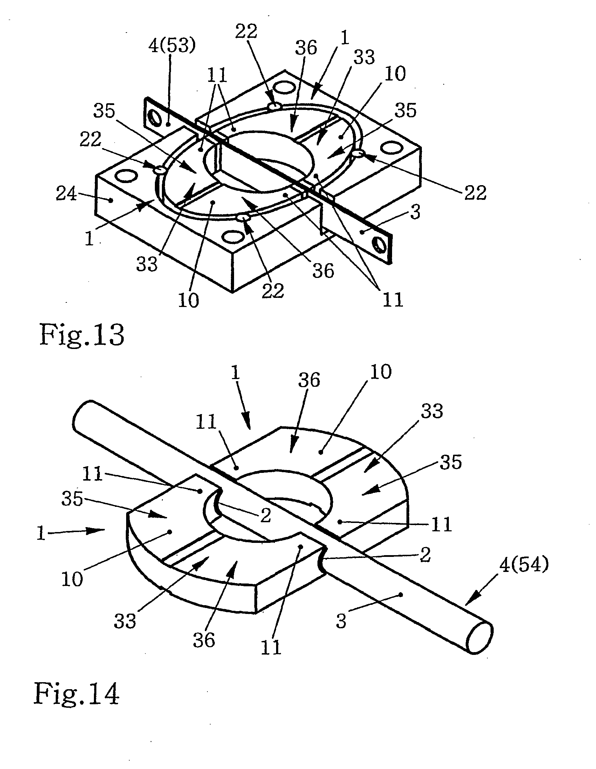

Figur 13 zeigt einen Ultraschallmotor, in dem das anzutreibende Element 4 als dünne und schmale Platte bzw. als Band 53 ausgeführt ist, das durch zwei gegenüberliegend angeordnete Aktoren 1 gehalten wird.

Figur 14 zeigt einen Ultraschallmotor, in dem das anzutreibende Element 4 als Rundstab 54 ausgeführt ist, der durch die zwei gegenüberliegend angeordneten Aktoren 1 gehalten wird. Es ist auch denkbar, das anzutreibende Element als hohlzylindrischen Stab auszuführen.

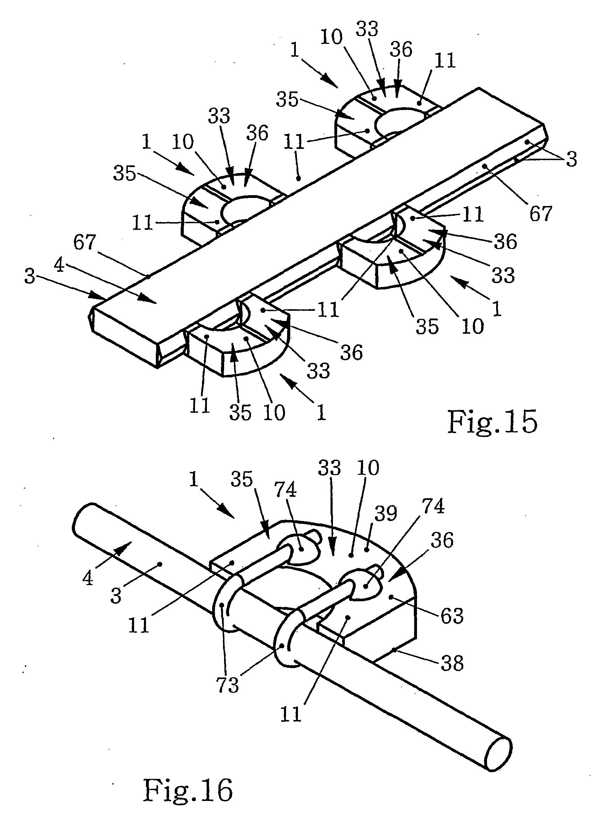

Figur 15 zeigt einen Ultraschallmotor, in dem das anzutreibende Element 4 durch mehrere zueinander versetzt angeordnete Aktoren 1 gehalten wird.

Figur 16 zeigt einen Ultraschallmotor, bei dem das anzutreibende Element 4 durch die auf der Oberfläche des Aktors 1 befestigten Federelemente 73 gehalten wird. Eine solche Befestigung kann durch Auflöten oder Aufkleben mit einem Tropfen 74 aus Lot oder Kleber auf die Elektrode 39 der Generatoren 35, 36 erfolgen.

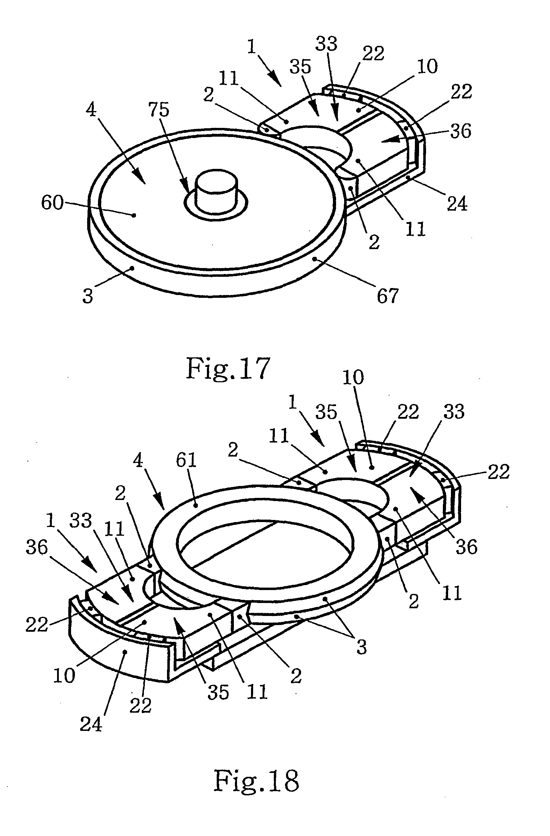

Figur 17 zeigt einen Ultraschallmotor, bei dem das anzutreibende Element 4 drehbar bzw. rotierbar angeordnet ist und die Form eines Tellers oder einer Scheibe 60 aufweist.

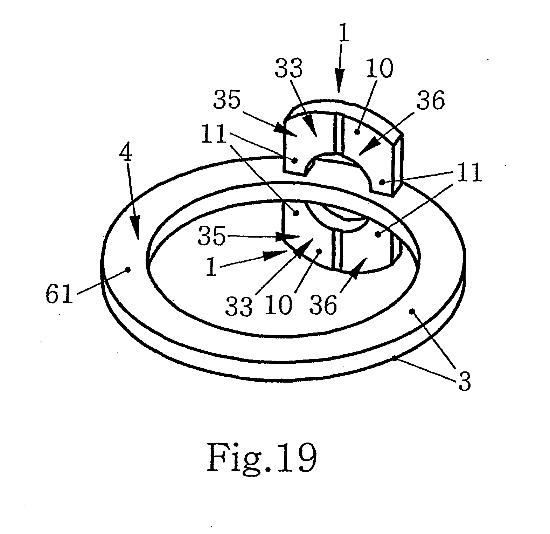

Die Figuren 18 und 19 zeigen Ultraschallmotoren, bei denen das anzutreibende Element 4 als Ring 61 ausgeführt ist und durch zwei oder mehrere gegenüberliegend angeordnete Aktoren 1 gehalten wird, wobei in Figur 18 die Friktionselemente 2 der Aktoren an der Außenumfangsfläche des Ringes 61 angreifen, während sie in Figur 19 an den in axialer Richtung weisenden Flächen des Ringes 61 angreifen.

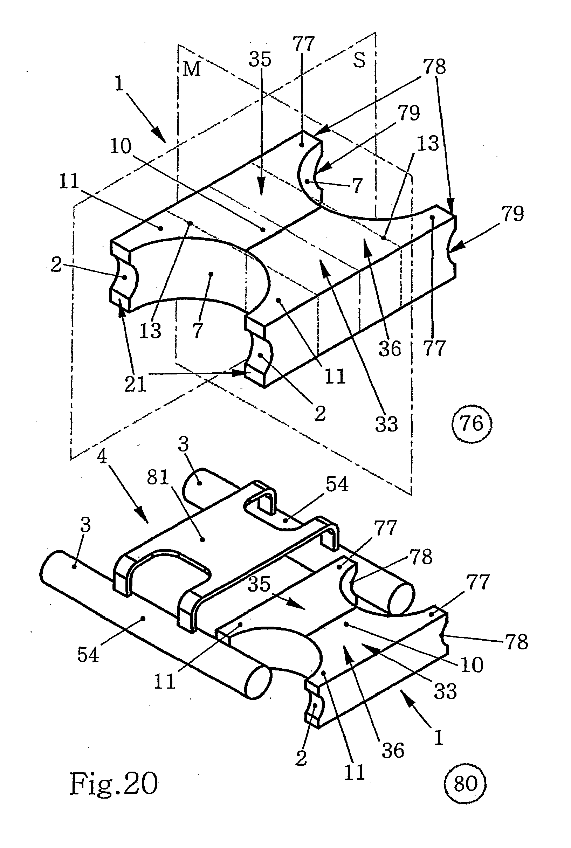

Gemäß den Positionen 76 und 80 von Figur 20 kann der Ultraschallaktor 1 des erfindungsgemäßen Ultraschallmotors über vier Stößelabschnitte 11 und 77 verfügen, wobei die Stößelabschnitte 77 spiegelbildlich zu den Stößelabschnitten 11 angeordnet sind und zusammen mit dem ansteuerbaren Abschnitt 10 und den Stößelabschnitten 11 den Resonator 33 für die asymmetrische zweidimensionale Ultraschallstehwelle bilden. Die spiegelbildliche Abbildung der Stößelabschnitte erfolgt bezogen auf die senkrecht zur Längssymmetrieebene S und senkrecht zu den Ebenen der Oberflächen 9 des Aktors 1 verlaufende Symmetriequerebene M. Die Stößelabschnitte 77 weisen auf ihren Stirnflächen 78 die Friktionselemente 79 auf.

Position 80 der Figur 20 zeigt ebenso einen Ultraschallmotor, bei dem der Aktor 1 zwei zusätzliche Stößelabschnitte 77 besitzt. Das anzutreibende Element 4 dieses Motors ist in Form von zwei Stäben 54 ausgeführt, die an einer Spannfeder 81 angeordnet sind.

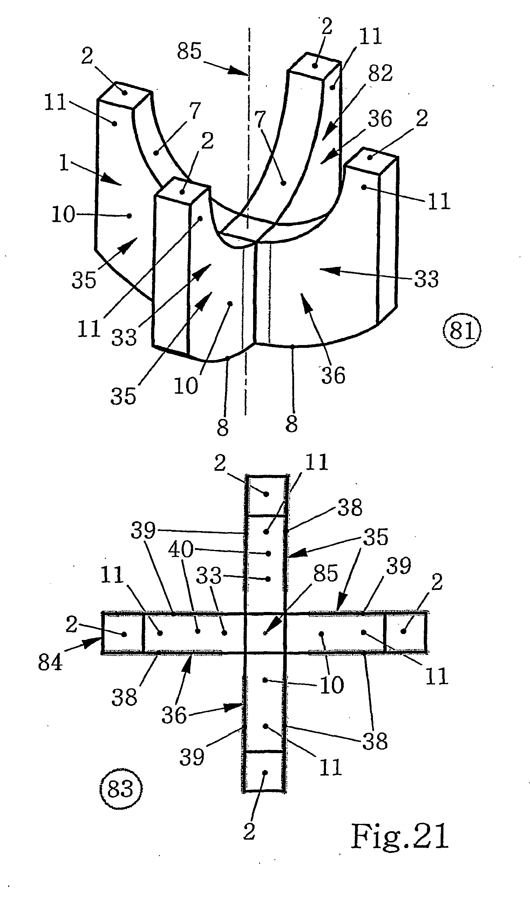

Gemäß Figur 21 kann der erfindungsgemäße Motor einen zweiten Aktor 82 aufweisen, der im Wesentlichen die gleiche Geometrie und den gleichen Aufbau wie der Aktor 1 aufweist, und der sich mit dem Aktor 1 so kreuzt, dass die Achsenprojektion 83 der beiden Aktoren ein symmetrisches Kreuz 84 bildet. Hierbei handelt es sich um eine Projektion längs der in Fig. 21 gezeigten Vertikafachse 85. Dabei besteht jeder der Aktoren 1 und 82 aus einen vom jeweils anderen unabhängigen Resonator für eine asymmetrische zweidimensionale Ultraschallstehwelle 33, gebildet aus seinen ansteuerbaren Teil 10 und zwei Stößelabschnitten 11, wobei jeder Aktor die Generatoren 35 und 36 aufweist. Dies erlaubt eine zweidimensionale relative Bewegung zwischen Motor und anzutreibendem Element.

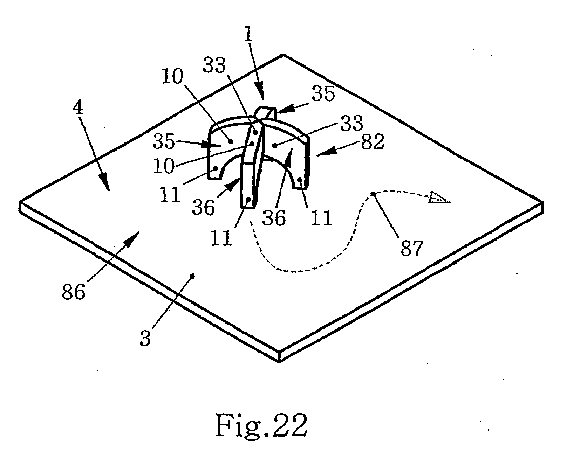

Figur 22 zeigt den Ultraschallmotor gemäß Figur 21 und dessen mögliche zweidimensionale Bewegungsbahn 87 auf einer Platte 86, die mit einer Friktionsschicht 3 versehen ist.

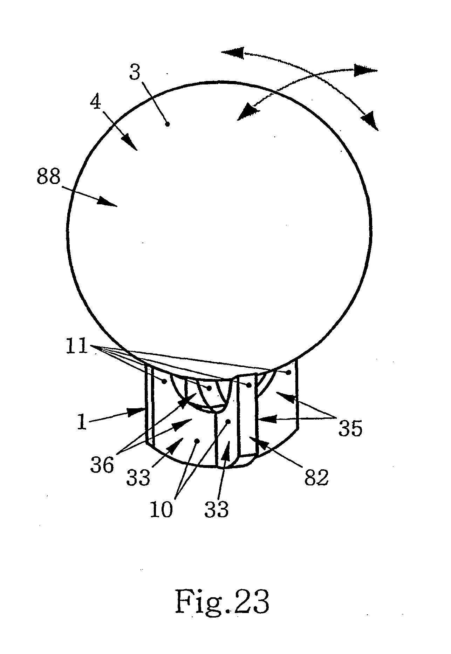

Figur 23 zeigt ebenso den Ultraschallmotor gemäß Figur 21 zusammen mit einem anzutreibenden Element in Form einer Kugel 88, die mit einer Friktionsschicht 3 versehen ist.

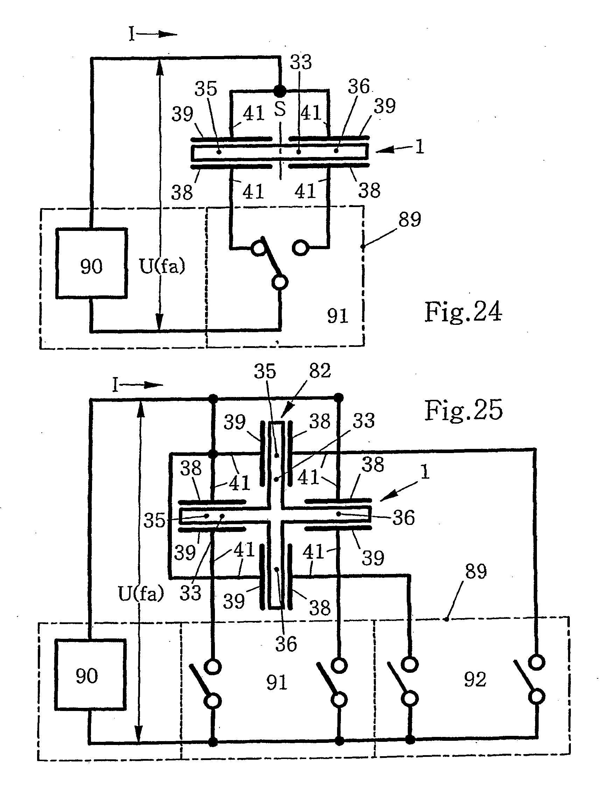

Figur 24 zeigt das Blockschaltbild einer elektrischen Erregervorrichtung 89 für einen erfindungsgemäßen Ultraschallmotor mit dem Aktor 1. Die Erregervorrichtung 89 besteht aus dem Erzeuger 90 der elektrischen Wechselspannung U mit der Frequenz fₐ und dem Umschalter 91. Der Umschalter 91 dient zum Verbinden des elektrischen Wechselspannungsgenerators 90 mit dem einen oder dem anderen Generator der asymmetrischen zweidimensionalen Ultraschallstehwelle 35 oder 36. Beim Verbinden des Erzeugers 90 mit dem Generator 35 oder 36 fließt über den Aktor 1 der Strom I.

Figur 25 zeigt das Blockschaltbild einer elektrischen Erregervorrichtung für einen weiteren erfindungsgemäßen Ultraschallmotor mit sich kreuzenden Ultraschallaktoren. Die elektrische Erregervorrichtung 89 dieses Motors weist einen zusätzlichen Umschalter 92 zum Verbinden der Generatoren 35 oder 36 des zusätzlichen Aktors 82 mit dem Erzeuger 90 auf.

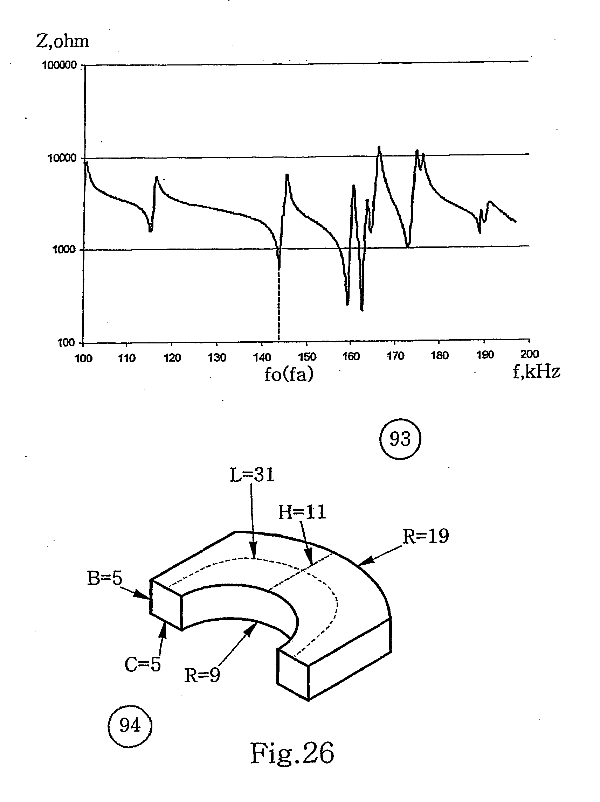

Die Position 93 von Figur 26 verdeutlicht die Abhängigkeit der Impedanz Z von der Erregerfrequenz f des Aktors 1, hergestellt aus Piezokeramik PIC 181 der Firma PI Ceramic, dessen Abmessungen, angegeben in mm, aus Position 94 von Figur 26 entnommen werden können. Die Spitze mit der Frequenz fₒ (144 kHz) in Position 93 stellt die Resonanzfrequenz der im erfindungsgemäßen Motor verwendeten asymmetrischen zweidimensionalen Ultraschallstehwelle dar.

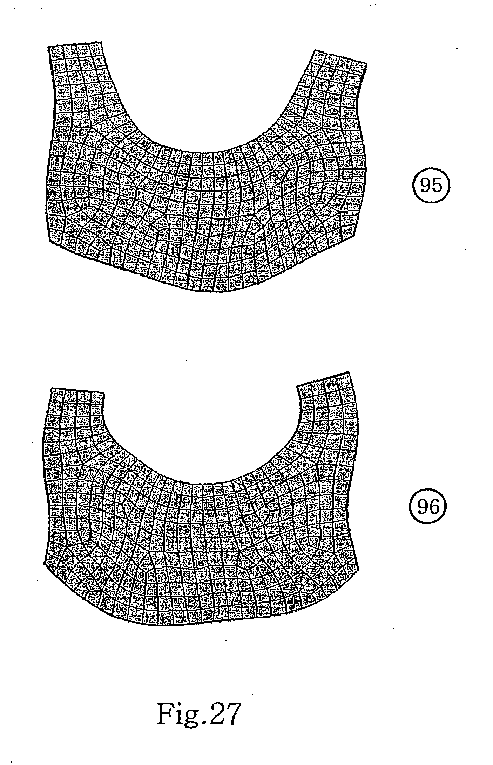

Die Positionen 95 und 96 von Figur 27 zeigen Computersimulationen von zwei Phasen mit maximaler Deformation des Aktors 1 eines erfindungsgemäßen Ultraschallmotors bei Erregung einer mit der Frequenz fₒ schwingenden asymmetrischen zweidimensionalen Ultraschallstehwelle.

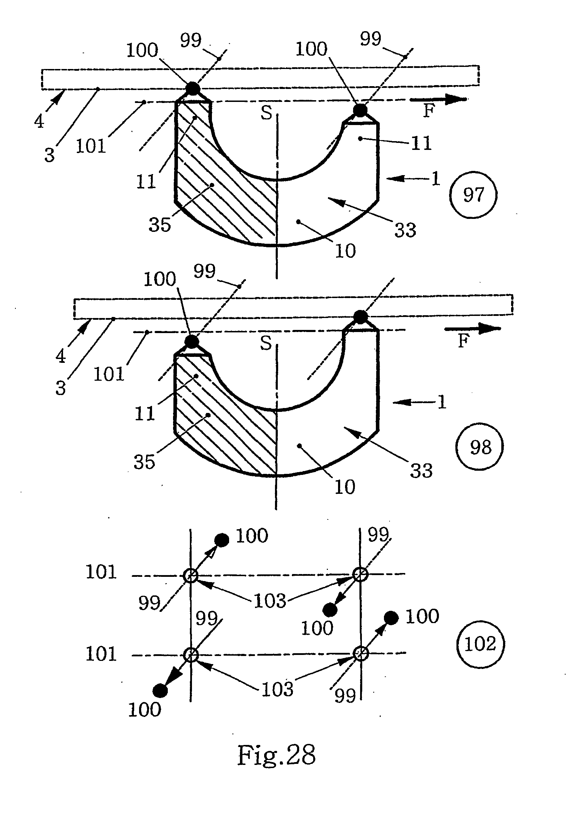

Die Positionen 97 und 98 von Figur 28 zeigen schematisch einen Aktor des erfindungsgemäßen Motors in den Momenten seiner maximalen Deformation. Die gestrichelte Linie 99 verdeutlicht hierbei die Bewegungsbahnen der auf den gegenüberliegenden Friktionselementen 2 des Aktors 1 angeordneten Materialpunkte 100. Die Linie 101 zeigt die Ausgangsposition der Materialpunkte 100 bei nicht erregtem Aktor 1. Die Pfeile in Position 102 von Figur 28 zeigen die Verschiebungsrichtung der Materialpunkte 100 bezogen auf die Ausgangsposition 103.

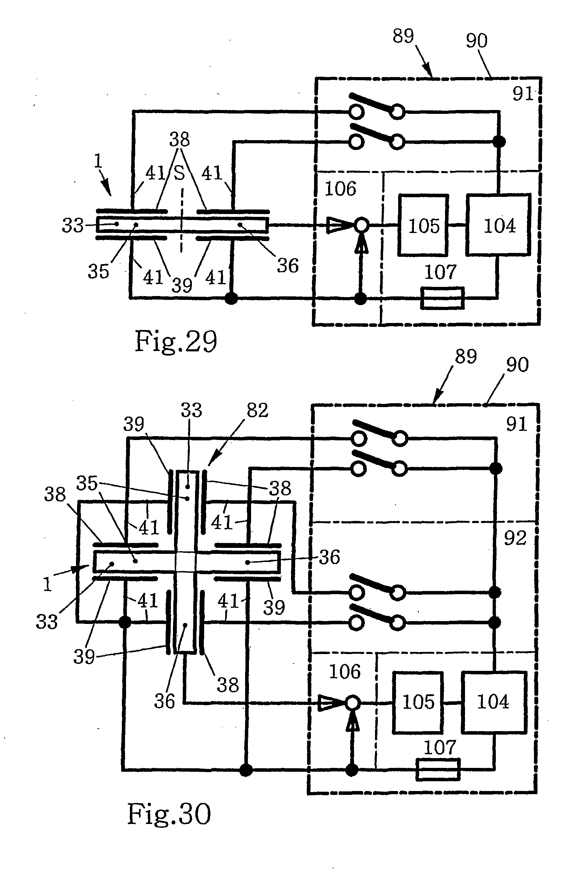

Figur 29 zeigt das Blockschaltbild einer elektrischen Erregervorrichtung für einen erfindungsgemäßen Ultraschallmotor, wobei der Erzeuger 90 der elektrischen Wechselspannung U den Leistungsverstärker 104, die Formierungseinrichtung des Erregersignals 105, den Rückkopplungskreis 106 und das Element des Rückkopplungskreises 107 umfasst.

Figur 30 zeigt das Blockschaltbild einer elektrischen Erregervorrichtung für einen erfindungsgemäßen Ultraschallmotor mit zwei sich kreuzenden Aktoren, wobei der Erzeuger 90 der elektrischen Wechselspannung U wiederum den Leistungsverstärker 104, die Formierungseinrichtung des Erregersignals 105, den Rückkopplungskreis 106 und das Element des Rückkopplungskreises 107 umfasst.

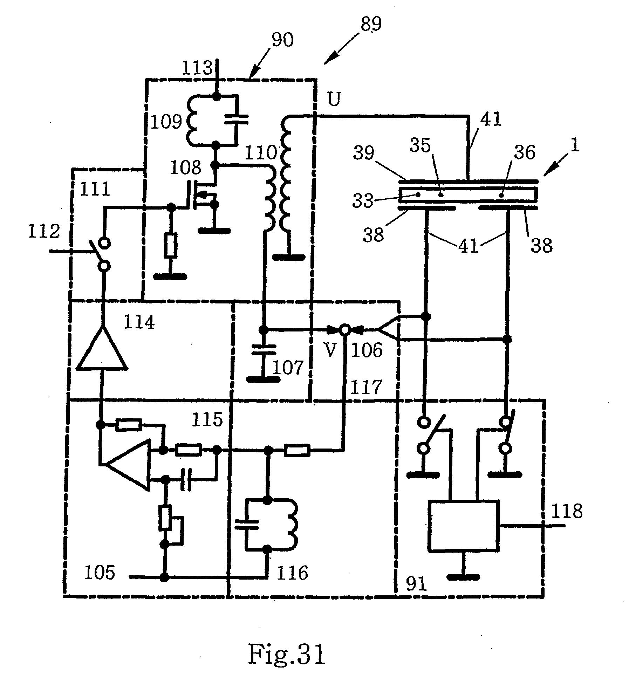

Figur 31 zeigt das Blockschaltbild einer weiteren Ausführungsform der elektrischen Erregervorrichtung für einen erfindungsgemäßen Ultraschallmotor. Hierbei besteht der Leistungsverstärker 104 des Erzeugers 90 der elektrischen Wechselspannung U aus dem Impulsverstärker 108 mit der Induktionspufferspule 109, dem Anpassungsübertrager 110 und dem Ausschalter 111 mit dem Steuereingang 112.

Der Impulsverstärker 108 weist einen Eingang für die Versorgungsspannung 113 auf, während die Formierungseinrichtung 105 den Verstärker 114 der Formierungseinrichtung 105, den Phasenschieber 115 und das Filter 116 aufweist. Das Filter 116 ist mit seinem Eingang 117 mit dem Rückkopplungskreis 106 verbunden. Der Umschalter 91 verfügt über einen Steuereingang 118.

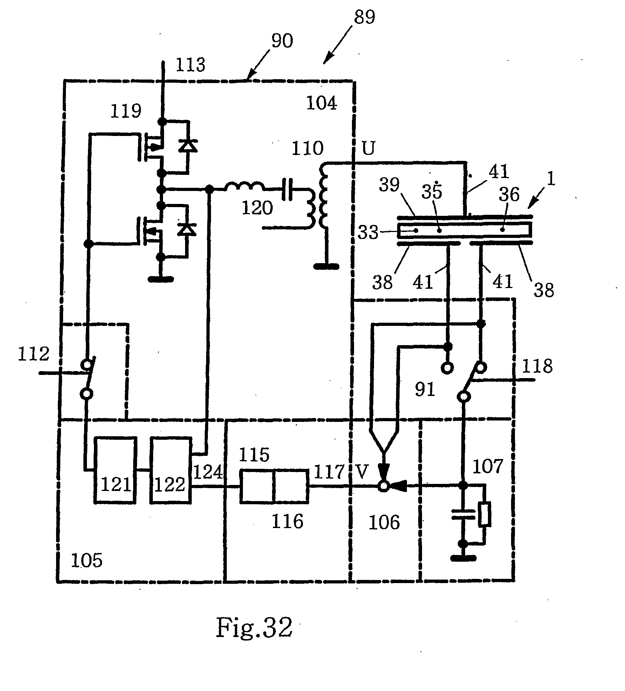

Figur 32 zeigt das Blockschaltbild einer weiteren Ausführungsform der elektrischen Erregervorrichtung für einen erfindungsgemäßen Ultraschallmotor. Hierbei weist der Leistungsverstärker 104 des Erzeugers 90 der elektrischen Wechselspannung einen Halbbrückenverstärker oder Brücken-Verstärker 119 und ein Trennfilter 120 auf. Die Formierungseinrichtung 105 umfasst den spannungsgesteuerten Generator 121, den Phasendetektor 122 mit dem Phasenstützeingang 122 und dem Phasenmesseingang 124. Der Phasenmesseingang 124 ist über den Phasenschieber 115 und das Filter 116 mit dem Rückkopplungskreis 106 verbunden.

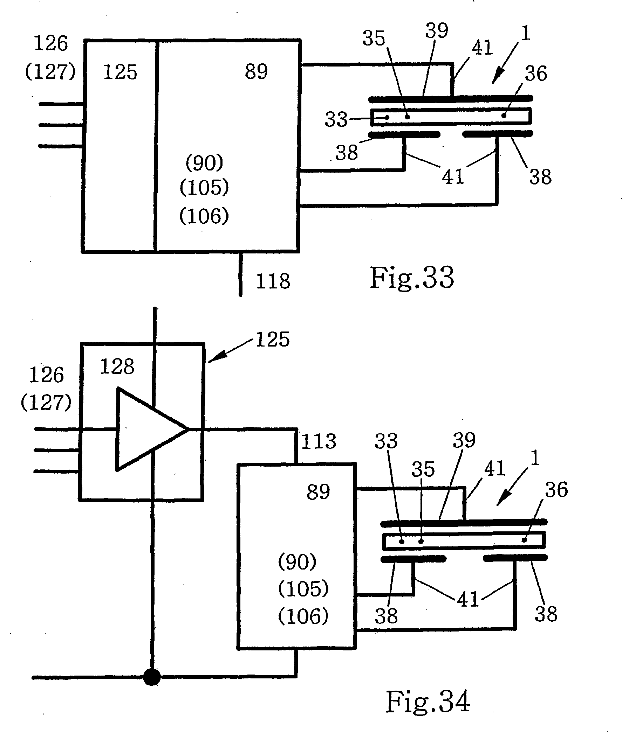

Figur 33 zeigt das Blockschaltbild einer weiteren Ausführungsform der elektrischen Erregervorrichtung für einen erfindungsgemäßen Ultraschallmotor. Hierbei ist die elektrische Erregervorrichtung 89 mit einer Amplitudennachstimmeinrichtung 125 der elektrischen Spannung U des angesteuerten Aktors 1 ausgerüstet. Die Amplitudennachstimmeinrichtung 125 kann einen Analogeingang 126 oder einen Digitaleineingang 127 aufweisen.

Figur 34 zeigt das Blockschaltbild einer weiteren Ausführungsform der elektrischen Erregervor richtung für einen erfindungsgemäßen Ultraschallmotor, bei dem die Amplitudennachstimmeinrichtung 125 als Linearleistungsverstärker 128 ausgeführt ist.

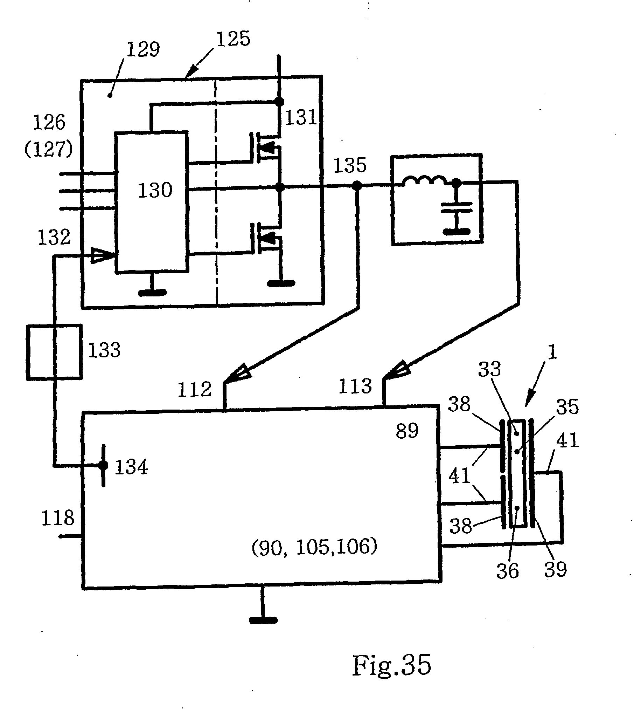

Figur 35 zeigt das Blockschaltbild einer weiteren Ausführungsform der elektrischen Erregervorrichtung für einen erfindungsgemäßen Ultraschallmotor, bei welchem die Amplitudennachstimmeinrichtung 125 als PWM-Controler 129 ausgeführt ist. Die Schaltung enthält den PWM-Modulator 130, dessen Ausgang mit dem Leistungsverstärker 131 verbunden ist. Der PWM-Modulator 130 besitzt den Synchronisationseingang 132, der über die Formierungseinrichtung 133 mit dem Signalkreis 134 des Erzeugers 90 der elektrischen Wechselspannung verbunden ist. Der Ausgang 135 des PWM-Controlers 129 kann direkt mit dem Eingang 112 der elektrischen Erregervorrichtung 89 oder über das Glättungsfilter mit seinem Eingang 113 verbunden sein.

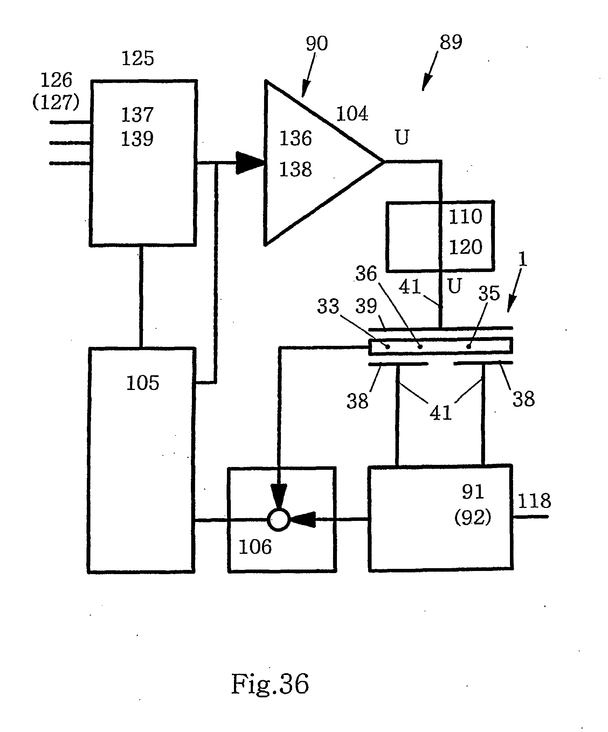

Figur 36 zeigt das Blockschaltbild einer weiteren Ausführungsform der elektrischen Erregervorrichtung für einen erfindungsgemäßen Ultraschallmotor. Hierbei kann der Leistungsverstärker 104 der elektrischen Erregervorrichtung 89 als Linearverstärker 136 und die Amplitudennachstimmeinrichtung 125 als programmierbarer Synthesizer 137 für eine sinusförmige oder quasisinusförmige elektrische Spannung ausgeführt sein. Daneben ist es möglich, dass der Leistungsverstärker 104 als D-Leistungsverstärker 138 und die Amplitudennachstimmeinrichtung 125 als PWM Modulator ausgeführt sind. Außerdem kann der Leistungsverstärker 104 der elektrischen Erregervorrichtung 89 als D-Leistungsverstärker 138 und die Amplitudennachstimmeinrichtung 125 als Sigma-Delta-Modulator 139 ausgeführt sein.

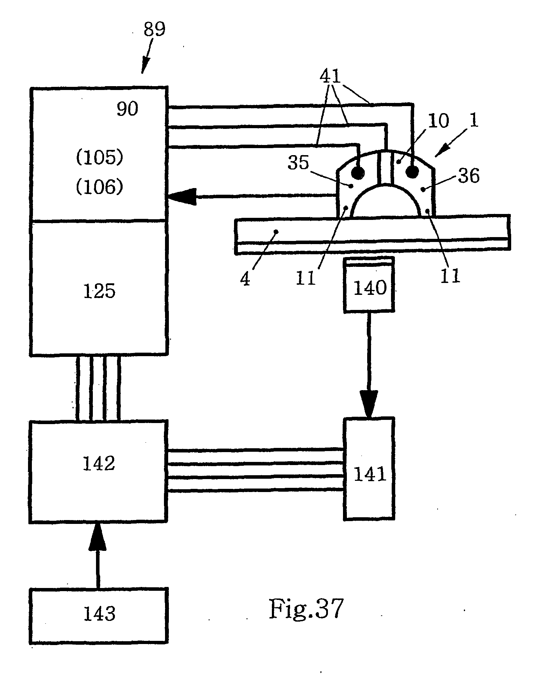

Figur 37 zeigt das Blockschaltbild zur Erläuterung einer möglichen Ansteuerung eines erfindungsgemäßen Ultraschallmotors. Hierbei weist das anzutreibende Element 4 einen Lagegeber 140 auf, der einen Interpolierer 141 umfasst. Weiterhin ist die elektrische Erregervorrichtung 89 mit einem Prozess-Controler 142 für die Solllage und / oder die Bewegungsgeschwindigkeit des anzutreibenden Elements 4 mit Hilfe des Steuerpults 143 versehen.

Die Funktionsweise des Ultraschallmotors kann auf folgende Weise erklärt werden. An den Elektroden 38 und 39 eines der Generatoren für die Ultraschallwelle, z. B. des Generators 35 des Aktors 1, wird vom Erzeuger 90 der elektrischen Erregervorrichtung 89 mit Hilfe des Umschalters 91 die elektrische Erregerspannung U angelegt. Die Frequenz fₐ der elektrischen Erregerspannung U ist im Wesentlichen gleich fₒ. Dabei wird im Aktor 1 eine akustische Stehwelle erzeugt. Da der Generator 35 asymmetrisch bezogen zur Symmetrieebene S angeordnet ist, ist die Stehwelle auch asymmetrisch zur Symmetrieebene S. Die Positionen 95 und 96 von Figur 27 geben die Form der erregten Welle bei maximaler Deformation wider. Diese Welle stellt eine asymmetrische Stehwelle dar.

Die Ausbildung einer Stehwelle mit einer solchen Form kann dadurch erklärt werden, dass diese Welle eine eigenständige Form einer asymmetrischen Stehwelle darstellt, die dieser Bauform des Aktors 1 eigen ist und die auf seiner eigenen Resonanzfrequenz fₒ oder nah zu dieser erregt wird. Durch die Erzeugung dieser Welle bewegen sich die auf den Stirnflächen 21 der Stößelabschnitte 11 des Aktors 1 befindenden Materialpunkte auf geraden oder stark gezogenen elliptischen Bewegungsbahnen. Da sich die Friktionselemente 2 auf den Stirnflächen 21 befinden, bewegen sich auch die Materialpunkte 100 der Friktionselemente auf den gleichen Bewegungsbahnen 99, so wie es in Figur 28 dargestellt ist. Dabei bewegen sich die auf den gegenüberliegenden Friktionselementen befindenden Materialpunkte 100 in entgegen gesetzter Phase.

Eine Stehwelle mit oben beschriebener Form tritt in Aktoren auf, bei denen das Verhältnis UH im Bereich zwischen 1,5-3,5, B im Bereich zwischen H/2 und H/10 und C zwischen H/2 und H/5 liegt. Zusätzlich muss der Aktor zumindest abschnittsweise die Form eines Ringsegments aufweisen, wobei der entsprechende Abschnitt eine hinreichend kleine Krümmung aufweist, so dass sich die im Aktor ausbreitende akustische Welle leicht drehen kann, was dazu führt, dass sich die Materialpunkte 100 der Oberflächen der Stirnseiten 21 der Stößelabschnitte 11 auf gleich oder annähernd gleich geneigten Bewegungsbahnen 99 bewegen.

Da die Friktionselemente 2 an die Friktionsoberfläche 3 des anzutreibenden Elementes 4 angepresst sind, führt eine solche geneigte Bewegungsbahn der Materialpunkte 100 zur Entstehung einer eine Bewegung auslösenden Kraft F. Die Kraft F führt zu einer Bewegung des anzutreibenden Elements 4 relativ zum Aktor 1 (oder zu einer Bewegung des Aktors 1 relativ zum anzutreibenden Element 4 bei Invertierung der Kinematik). Die Bewegung erfolgt in parallelen Ebenen zu den Oberflächen 9 des Aktors 1.

Da der zweite Generator 36 symmetrisch zum ersten Generator 35 und gleichzeitig asymmetrisch zur Symmetrieebene S angeordnet ist, hat das Betätigen des Umschalters 91 in die Position, bei der der Generator 36 erregt wird, eine Umkehr der Bewegungsrichtung des anzutreibenden Elementes 4 zur Folge.

Für den Aktor 1 des erfindungsgemäßen Ultraschallmotors gibt es die zwei in Figur 5 und Figur 6 dargestellten Grundkonstruktionen für die Ultraschallwellengeneratoren 35 und 36. Durch die Verwendung von Ultraschallwellengeneratoren 35 und 36 mit nur einer Piezokeramikschicht, die zwischen den Elektroden 38 und 39 angeordnet ist, vereinfacht sich die Herstellungstechnologie für die Aktoren 1. Durch die Anwendung von Multilayergeneratoren mit mehreren Piezokeramikschichten und zwischen diesen angeordneten Elektroden 38 und 39 ist es möglich, die Amplitude der Erregerspannung U abzusenken.

Für den erfindungsgemäßen Ultraschallmotor sind verschiedene Ausführungsformen für die Friktionselemente 2 mit unterschiedlicher Form der Friktionsoberflächen 43 und verschiedene Formen für die Friktionsschichten 3 des anzutreibenden Elementes 4 möglich.

Durch die Auswahl einer geeigneten Gestaltung des anzutreibenden Elementes 4 können Motoren für eine Linear- oder Drehbewegung realisiert werden. Durch die Verwendung von anzutreibenden Elementen 4 mit Multilayerstruktur ist es möglich, parasitäre Schwingungen in dem anzutreibenden Element zu reduzieren bzw. zu unterdrücken, wodurch sich das Verhalten des Friktionskontaktes verbessert.

Die Friktionselemente 2 des Aktors 1 können mit Hilfe elastischer Elemente 22, die z. B aus einem gummielastischen Werkstoff hergestellt sind, an die Friktionsschicht 3 des anzutreibenden Elements angepresst werden. Zum Anpressen können auch Flachfedern 71 oder U-förmig Federn 69 aus Metall oder Plastwerkstoff verwendet werden. Zur Verringerung der Reibungsverluste können Federelemente 73 auf der Oberfläche des Aktors 1 angeordnet sein.

Die anzutreibenden Elemente 4 können durch gegenüberliegend oder versetzt zueinander angeordnete Aktoren fixiert bzw. gehalten sein.

Bei einem erfindungsgemäßen Ultraschallmotor, bei welchem der Aktor gemäß Figur 20 zwei zusätzliche Stößelabschnitte 77 aufweist, bewegen sich die Materialpunkte der Stirnflächen 78 der Stößelabschnitte 77 auf Bewegungsbahnen in Analogie zu den Bewegungsbahnen 99 von Figur 28. Das bedeutet, dass das anzutreibende Element 4 eines solchen Motors in Form von zwei mit der Spannfeder 81 zusammengepressten Stäben 54 ausgeführt werden kann, wie dies in Position 80 von Figur 20 dargestellt ist.

Gemäß einer weiteren Ausführungsform des erfindungsgemäßen Ultraschallmotors kann dieser zusätzlich zu dem Hauptaktor 1 einen sich mit diesem kreuzenden Aktor 82 aufweisen, so dass die Achsenprojektion 83 der beiden Aktoren ein symmetrisches Kreuz bildet. Dadurch kann eine zweidimensionale relative Bewegung zwischen Motor und anzutreibendem Element realisiert werden. Dies wird durch die Erregung eines der Ultraschallwellengeneratoren 35 oder 36 erreicht. Dafür muss einer der Umschalter 91 oder 92 betätigt werden. Die gleichzeitige Erregung von zwei benachbarten Ultraschallwellengeneratoren 35, 36 ermöglicht eine Umkehr der Bewegungsrichtung auf der gekrümmten Linie 87 von Figur 22.

In dem erfindungsgemäßen Motor mit zwei sich kreuzenden Aktoren 1 und 82 kann das anzutreibende Element 4 eine Kugel 88 sein, wie dies in Figur 23 dargestellt ist. In diesem Fall kann die Drehung der Kugel in einer beliebigen durch seine Oberfläche 3 vorgegebenen Richtung erfolgen.

Im erfindungsgemäßen Motor muss die Frequenz fₐ der elektrischen Erregerspannung U, die von der elektrischen Erregervorrichtung 89 bereitgestellt wird, im Wesentlichen gleich der Frequenz fₒ sein. Dafür besteht der Wechselspannungserzeuger 90 aus der Formierungseinrichtung des Erregersignals 105 und dem Rückkopplungskreis 106. Der Leistungsverstärker 104, die Formierungseinrichtung des Erregersignals 105 und der Rückkopplungskreis 106 bilden einen geschlossenen Kreis, der die Frequenz der elektrischen Spannung, die den Aktor 1 erregt, gleich oder nah zu der im Aktor erzeugten Resonanzfrequenz der asymmetrischen zweidimensionalen Ultraschallstehwelle ist. Dies erfolgt dadurch, dass die von dem Rückkopplungselement oder von der freien Erregerelektrode 38 oder einer Hilfselektrode des Aktors 1 erzeugte Rückkopplungsspannung V an den Rückkopplungskreis 106 angelegt wird.

Die Figuren 31 und 32 zeigen verschiedene Ausführungsbeispiele der Erregervorrichtung mit analogen Bauelementen. Die Rückkopplungsspannung V gelangt auf den Eingang 117 des Filters 116 der Formierungseinrichtung 105. Das Filter 116 filtert die erste Harmonische der Spannung V heraus. Danach wird die erste Harmonische an den Phasenschieber 115 geleitet.

Es sind zwei grundsätzliche Funktionsprinzipien der Erregervorrichtung 89 möglich. Entsprechend dem ersten Funktionsprinzip funktioniert die Erregervorrichtung 89 wie ein sich selbsterregender Generator, dessen Erregerfrequenz durch die mechanischen Parameter des Aktors 1 vorgegeben werden. Figur 31 zeigt die elektrische Schaltung einer solchen Erregervorrichtung 89. Dabei wird die Schaltung mit Hilfe des Phasenschiebers 115 und des Verstärkers 114 so ausbalanciert, dass bei der Frequenz fₒ oder nah zu dieser Frequenz die Phasenverschiebung im offenen Rückkopplungskreis gleich Null und der Verstärkungskoeffizient größer 1 ist.

Entsprechend dem zweiten Funktionsprinzip arbeitet die elektrische Erregervorrichtung 89 wie ein PLL-System, welches der Phasenspannung des Rückkopplungskreises folgt, die durch die mechanischen Parameter des Aktors 1 festgelegt ist. Dafür besteht die Formierungseinrichtung 105 aus dem Phasendetektor 122 und dem spannungsgesteuerten Generator 121.

Die Funktion der Formierungseinrichtung 105 kann auch durch einen programmierbaren Mikroprozessor realisiert werden.

Beim erfindungsgemäßen Ultraschallmotor kann gemäß Figur 33 die elektrische Erregervorrichtung 89 mit einer Amplitudennachstimmeinrichtung 125 für die Spannung U ausgerüstet sein, die zur Steuerung über einen Analogeingang 126 oder einen Digitaleingang 127 verfügt.

Die Amplitudennachstimmeinrichtung 125 kann als Linearleistungsverstärker 128 aufgebaut sein, der eine auf den Eingang 113 der Versorgungsspannung des Leistungsverstärkers 90 geleitete Spannung bereitstellt.

Ferner kann die Amplitudennachstimmeinrichtung 125 als PWM-Controler 129 ausgeführt sein. In einer solchen Amplitudennachstimmeinrichtung stellt der PWM-Controler ein Impulssignal bereit, dessen Impulslänge durch das am Eingang 126 (127) anliegende Steuersignal vorgegeben wird. Dieses Signal wird durch den Leistungsverstärker 131 verstärkt. Dadurch entsteht am Ausgang 135 des Controlers 129 eine rechteckige modulierte PWM-Spannung. Diese Spannung kann direkt an den Steuereingang 112 des Ausschalters 111 oder über das Glättfilter an den Eingang 113 des Wechselspannungserzeugers (Impulsverstärker, Brücken/Halbbrückenverstärker) 90 angelegt werden.

In allen diesen Fällen bewirkt eine Änderung des Steuersignals am Eingang 126 eine Änderung der Amplitude der Spannung U, die den Aktor 1 ansteuert, und dies führt zu einer Änderung der Bewegungsgeschwindigkeit des anzutreibenden Elementes 4.

In dem in Figur 36 dargestellten Blockschaltbild für die elektrische Erregervorrichtung eines erfindungsgemäßen Ultraschallmotors kann die Amplitudennachstimmeinrichtung 125 als programmierbarer Synthesizer einer sinusförmigen oder quasisinusförmigen elektrischen Spannung mit der Frequenz fₐ ausgeführt sein. Die synthetisierte Spannung mit der vorgegebenen Amplitude wird an den Linearleistungsverstärker 136 gelegt, durch ihn verstärkt und danach als Erregerspannung U auf einen der Generatoren 35 und 36 des Aktors 1 geleitet.

Hierbei ist zudem möglich, die Amplitudennachstimmeinrichtung 125 als PWM-Modulator auszuführen, der eine rechteckige PWM-Spannung mit der Frequenz fₐ bereitstellt, deren Impulslänge proportional zum Augenblickwert der Sinusspannung ist. Diese Spannung gelangt auf den D-Leistungsverstärker 138 und danach auf das Filter 120. Dadurch wird am Ausgang des Filters 120 eine Sinusspannung U bereitgestellt, die einen der Generatoren 35 oder 36 des Aktors 1 ansteuert.

Weiterhin ist es möglich, die Amplitudennachstimmeinrichtung 125 als einen Sigma-Delta-Modulator auszuführen, der eine Gruppe von Einzelsignalen erzeugt, die in sich die Information über die Frequenz fₐ und über die Amplitude der Sinusspannung tragen. Die Einzelimpulsgruppe gelang auf den D-Leistungsverstärker 138, wird durch ihn verstärkt und wird danach auf das Filter 120 geleitet. Dadurch entsteht am Ausgang des Filters 120 eine Sinusspannung U.

In den Figuren 33 bis 36 besteht die elektrische Erregervorrichtung 89 aus einen Rückkopplungskreis 106. Dank des Rückkopplungskreises wird die Frequenz fₐ der Erregerspannung U durch die mechanischen Parameter des Aktors 1 vorgegeben. Deshalb ändert sich ihre Lage auf der Frequenzcharakteristik des Aktors 1, bezogen auf die Frequenz fₒ, bei Temperatur- und Laständerungen des Aktors 1 nicht. Dies stabilisiert seine Funktion.

Im erfindungsgemäßen Ultraschallmotor kann das anzutreibende Element 4 mit einem Lagegeber 140 mit dem Interpolierer versehen sein und die elektrische Erregervorrichtung 89 kann einen Prozes-Controler 142 für die vorgegebene Lage oder die Bewegungsgeschwindigkeit des anzutreibenden Elements 4 durch das Steuerpult 143 aufweisen. In einer solchen Motorausführung kann man die Position, die Bewegungsgeschwindigkeit oder das Bewegungsprofil des anzutreibenden Elementes 4 vorgeben.

## Patentansprüche

1. Ultraschallmotor, der zumindest einen Ultraschallaktor (1), wenigstens zwei an dem Ultraschallaktor (1) angeordnete Friktionselemente (2), die zum Kontakt mit einem anzutreibenden Element (4) vorgesehen sind, und eine elektrische Erregervorrichtung (89) umfasst, und der Ultraschallaktor (1)
- wenigstens abschnittsweise als Ringsegment mit gekrümmten und/oder ebenen Seitenflächen (6, 7, 8) und die Seitenflächen begrenzenden Oberflächen (9) ausgeführt ist;
- eine Symmetrieebene S besitzt, welche die Oberflächen (9) senkrecht schneidet;
- eine Dicke B aufweist, die dem Abstand der Oberflächen (9) entspricht;
- eine mittlere Länge L besitzt, wobei die mittlere Länge L die Länge der Linie ist, die in der Oberflächen (9) im gleichen Abstand zu den jeweiligen in radialer Richtung gegenüberliegenden Seitenflächen (6, 7, 8) verläuft;
- eine mittlere Höhe H aufweist, welche der Ausdehnung der Oberflächen (9) entlang der Symmetrieebene S entspricht;
- und Stirnflächen (21) mit einer Breite C aufweist, an welchen die Friktionselemente (2) angeordnet sind,
**dadurch gekennzeichnet,**
**dass** der Ultraschallaktor (1) einen Resonator (33) einer asymmetrischen zweidimensionalen Stehwelle aufweist, wobei der Resonator (33) einen ansteuerbaren Abschnitt (10) und wenigstens zwei spiegelsymmetrisch zueinander angeordnete Stößelabschnitte (11) aufweist, und der ansteuerbare Abschnitt (10) und die Stößelabschnitte (11) einstückig miteinander ausgeführt sind, und der Resonator (33) zumindest einen Generator (35, 36) der asymmetrischen zweidimensionalen Stehwelle umfasst, und das Verhältnis UH zwischen 1,5 und 3,5 liegt, und B zwischen H/2 und H/10, und C zwischen H/2 und H/5 liegt.

2. Ultraschallmotor nach Anspruch 1, **dadurch gekennzeichnet, dass** der Ultraschallaktor (1) als Segment eines im Wesentlichen runden oder elliptischen oder parabolischen Ringes (5) ausgeführt ist.

3. Ultraschallmotor nach Anspruch 1, **dadurch gekennzeichnet, dass** der Ultraschallaktor (1) als Segment eines eckigen Ringes (5) ausgeführt ist.

4. Ultraschallmotor nach Anspruch 1, **dadurch gekennzeichnet, dass** der Ultraschallaktor (1) zwei gekrümmte Seitenflächen (7, 8) aufweist, und die beiden gekrümmten Seitenflächen (7, 8) über die Stirnflächen (21) und zwei ebene Seitenflächen (6) miteinander verbunden sind.

5. Ultraschallmotor nach zumindest einem der vorangegangenen Ansprüche, **dadurch gekennzeichnet, dass** dieser zwei sich kreuzende Ultraschallaktoren (1, 82) aufweist.

6. Ultraschallmotor nach zumindest einem der vorangegangenen Ansprüche, **dadurch gekennzeichnet, dass** der Generator (35, 36) der asymmetrischen zweidimensionalen Stehwelle eine einschichtige oder mehrschichtige Piezokeramik (40) aufweist.

7. Ultraschallmotor nach zumindest einem der vorangegangenen Ansprüche, **dadurch gekennzeichnet, dass** die Friktionselemente (2) eine ebene und/oder konvexe und/oder konkave und/oder gerippte Friktionsoberfläche (43) aufweisen.

8. Ultraschallmotor nach zumindest einem der vorangegangen Ansprüche, **dadurch gekennzeichnet, dass** das anzutreibende Element (4) als Stab oder Platte oder Ring oder Scheibe oder als Teil eines Rings oder als Teil einer Scheibe ausgeführt ist und jeweils einen einschichtigen oder mehrschichtigen Aufbau aufweist.

9. Ultraschallmotor nach zumindest einem der vorangegangenen Ansprüche, **dadurch gekennzeichnet, dass** das anzutreibende Element (4) als Scheibe ausgeführt ist und durch ein Lagerelement, vorzugsweise durch ein Rollenlager (23), gelagert ist.

10. Ultraschallmotor nach zumindest einem der vorangegangenen Ansprüche, **dadurch gekennzeichnet, dass** das anzutreibende Element (4) durch gegenüberliegend oder versetzt zueinander angeordnete Ultraschallaktoren (1) gehalten ist.

11. Ultraschallmotor nach zumindest einem der vorangegangenen Ansprüche, **dadurch gekennzeichnet, dass** das anzutreibende Element (4) durch wenigstens ein auf zumindest einer der Oberflächen (9) des Ultraschallaktors (1) angeordnetes elastisches Element, vorzugsweise durch ein Federelement (73), gehalten ist.

12. Ultraschallmotor nach zumindest einem der vorangegangenen Ansprüche, **dadurch gekennzeichnet, dass** die elektrische Erregervorrichtung (89) einen Erzeuger (90) einer elektrischen Wechselspannung umfasst, und der Erzeuger (90) aus einem Leistungsverstärker (104), einer Formierungseinrichtung des Erregersignals (105) und einem Rückkopplungskreis (106) besteht, die einen geschlossenen Kreis bilden, der die Frequenz der elektrischen Spannung des angesteuerten Aktors gleich oder nah zur Resonanzfrequenz der im Aktor erzeugten asymmetrischen zweidimensionalen Ultraschallstehwelle hält.

13. Ultraschallmotor nach zumindest einem der vorangegangenen Ansprüche, **dadurch gekennzeichnet, dass** die elektrische Erregervorrichtung (89) eine Amplitudennachstimmeinrichtung (125) des angeregten Ultraschallaktors aufweist.

14. Ultraschallmotor nach zumindest einem der vorangegangenen Ansprüche, **dadurch gekennzeichnet, dass** die Amplitudennachstimmeinrichtung (125) als analoger Leistungsverstärker ausgeführt ist.

15. Ultraschallmotor nach zumindest einem der vorangegangenen Ansprüche, **dadurch gekennzeichnet, dass** die Amplitudennachstimmeinrichtung (125) als PWM-Controler (129) ausgeführt ist.

16. Ultraschallmotor nach zumindest einem der vorangegangenen Ansprüche, **dadurch gekennzeichnet, dass** der Leistungsverstärker (104) der elektrischen Erregervorrichtung (89) des Ultraschallaktors (1) als Linearverstärker und die Amplitudennachstimmeinrichtung (125) als programmierbarer Synthesizer einer sinusförmigen oder quasisinusförmigen elektrischen Spannung ausgeführt ist.

17. Ultraschallmotor nach zumindest einem der vorangegangenen Ansprüche, **dadurch gekennzeichnet, dass** der Leistungsverstärker (104) der elektrischen Erregervorrichtung (89) des Ultraschallaktors (1) als D-Leistungsverstärker und die Amplitudennachstimmeinrichtung (125) als PWM-Modulator ausgeführt ist.

18. Ultraschallmotor nach zumindest einem der vorangegangenen Ansprüche, **dadurch gekennzeichnet, dass** der Leistungsverstärker (104) der elektrischen Erregervorrichtung (89) des Ultraschallaktors als D-Leistungsverstärker und die Amplitudennachstimmeinrichtung (125) als Sigma-Delta-Modulator ausgeführt ist.

19. Ultraschallmotor nach zumindest einem der vorangegangenen Ansprüche, **dadurch gekennzeichnet, dass** das anzutreibende Element (4) mit einem Lagegeber (140) und die elektrische Erregervorrichtung (89) mit einer prozessorgeführten Nachstimmeinrichtung für die vorgegebene Lage oder die Bewegungsgeschwindigkeit des anzutreibenden Elements (4) versehen ist.

## Claims

1. Ultrasonic motor, which comprises at least one ultrasonic actuator (1), at least two friction elements (2), which are arranged on the ultrasonic actuator (1) and are provided for the contact with an element (4) to be driven, and an electrical excitation device (89), and the ultrasonic actuator (1)
- is designed at least in some sections as an annular segment having curved and/or planar side faces (6, 7, 8) and surfaces (9) that delimit the side faces;
- has a plane of symmetry S, which intersects the surfaces (9) perpendicularly;
- has a thickness B, which corresponds to the distance between the surfaces (9);
- has a mean length L, the mean length L being the length of the line that runs in the surfaces (9) at the same distance from the respective side faces (6, 7, 8) lying oppositely in the radial direction;
- has a mean height H, which corresponds to the extent of the surfaces (9) along the plane of symmetry S;
- and end faces (21) with a width C, on which the friction elements (2) are arranged,
**characterized**
**in that** the ultrasonic actuator (1) has a resonator (33) of an asymmetrical two-dimensional standing wave, wherein the resonator (33) has an activatable section (10) and at least two push-rod sections (11) arranged mirror-symmetrically in relation to one another, and the activatable section (10) and the push-rod sections (11) are designed as together forming one piece, and the resonator (33) comprises at least one generator (35, 36) of the asymmetrical two-dimensional standing wave, and the ratio L/H lies between 1.5 and 3.5, and B lies between H/2 and H/10, and C lies between H/2 and H/5.

2. Ultrasonic motor according to Claim 1, **characterized in that** the ultrasonic actuator (1) is designed as a segment of a substantially round or elliptical or parabolic ring (5).

3. Ultrasonic motor according to Claim 1, **characterized in that** the ultrasonic actuator (1) is designed as a segment of an angular ring (5).

4. Ultrasonic motor according to Claim 1, **characterized in that** the ultrasonic actuator (1) has two curved side faces (7, 8), and the two curved side faces (7, 8) are connected to one another via the end faces (21) and two planar side faces (6).

5. Ultrasonic motor according to at least one of the preceding claims, **characterized in that** it has two crossing ultrasonic actuators (1, 82).

6. Ultrasonic motor according to at least one of the preceding claims, **characterized in that** the generator (35, 36) of the asymmetrical two-dimensional standing wave comprises a single-layered or multi-layered piezoceramic (40).

7. Ultrasonic motor according to at least one of the preceding claims, **characterized in that** the friction elements (2) have a planar and/or convex and or concave and/or ribbed frictional surface (43).

8. Ultrasonic motor according to at least one of the preceding claims, **characterized in that** the element (4) to be driven is designed as a rod or plate or ring or disc or as part of a ring or as part of a disc and respectively has a single-layered or multi-layered structure.

9. Ultrasonic motor according to at least one of the preceding claims, **characterized in that** the element (4) to be driven is designed as a disc and is mounted by a bearing element, preferably by a roller bearing (23).

10. Ultrasonic motor according to at least one of the preceding claims, **characterized in that** the element (4) to be driven is held by ultrasonic actuators (1) arranged lying oppositely or offset in relation to one another.

11. Ultrasonic motor according to at least one of the preceding claims, **characterized in that** the element (4) to be driven is held by at least one elastic element arranged on at least one of the surfaces (9) of the ultrasonic actuator (1), preferably by a spring element (73).

12. Ultrasonic motor according to at least one of the preceding claims, **characterized in that** the electrical excitation device (89) comprises a generator (90) of an electrical a.c. voltage, and the generator (90) consists of a power amplifier (104), a shaping device of the excitation signal (105) and a feedback circuit (106), which form a closed loop, which keeps the frequency of the electrical voltage of the activated actuator equal or close to the resonant frequency of the asymmetrical two-dimensional ultrasonic standing wave generated in the actuator.

13. Ultrasonic motor according to at least one of the preceding claims, **characterized in that** the electrical excitation device (89) has an amplitude retuning device (125) of the excited ultrasonic actuator.

14. Ultrasonic motor according to at least one of the preceding claims, **characterized in that** the amplitude retuning device (125) is designed as an analogue power amplifier.

15. Ultrasonic motor according to at least one of the preceding claims, **characterized in that** the amplitude retuning device (135) is designed as a PWM controller (129).

16. Ultrasonic motor according to at least one of the preceding claims, **characterized in that** the power amplifier (104) of the electrical excitation device (89) of the ultrasonic actuator (1) is designed as a linear amplifier and the amplitude retuning device (125) is designed as a programmable synthesizer of a sinusoidal or quasi-sinusoidal electrical voltage.

17. Ultrasonic motor according to at least one of the preceding claims, **characterized in that** the power amplifier (104) of the electrical excitation device (89) of the ultrasonic actuator (1) is designed as a D power amplifier and the amplitude retuning device (125) is designed as a PWM modulator.

18. Ultrasonic motor according to at least one of the preceding claims, **characterized in that** the power amplifier (104) of the electrical excitation device (89) of the ultrasonic actuator is designed as a D power amplifier and the amplitude retuning device (125) is designed as a sigma-delta modulator.

19. Ultrasonic motor according to at least one of the preceding claims, **characterized in that** the element (4) to be driven is provided with a position sensor (140) and the electrical excitation device (89) is provided with a processor-controlled retuning device for the predetermined position or the rate of movement of the element (4) to be driven.

## Revendications

1. Moteur à ultrasons comprenant au moins un actionneur ultrasonique (1), au moins deux éléments de frottement (2) disposés au niveau de l'actionneur ultrasonique (1) et servant à la mise en contact avec un élément (4) à frotter et un dispositif d'excitation électrique (89), ledit actionneur ultrasonique (1) :
- prenant au moins en partie la forme d'un segment annulaire doté de surfaces latérales (6, 7, 8) planes et/ou coudées et des surfaces (9) délimitant les surfaces latérales ;
- possédant un plan symétrique S croisant les surfaces (9) à la perpendiculaire ;
- comportant une épaisseur B correspondant à l'écartement entre les surfaces (9) ;
- possédant une longueur médiane L, la longueur médiane L étant la longueur de la ligne s'étendant dans les surfaces (9) à même distance par rapport aux surfaces latérales (6, 7, 8) respectives opposées dans la direction radiale ;
- comportant une hauteur médiane H correspondant à la dilatation des surfaces (9) le long du plan symétrique S ; et
- comportant des surfaces frontales (21) de largeur C au niveau desquelles sont disposés les éléments de frottement (2) ; ;
**caractérisé en ce que** :
l'actionneur ultrasonique (1) comporte un résonateur (33) d'onde stationnaire bidimensionnelle asymétrique, le résonateur (33) comportant une section (10) excitable et au moins deux sections de poussoir (11) disposées en symétrie en miroir l'une par rapport à l'autre et la section (10) excitable et les sections de poussoir (11) étant réalisées d'un seul tenant les unes avec les autres et le résonateur (33) comprenant au moins un générateur (35, 36) d'onde stationnaire bidimensionnelle asymétrique et le rapport L/H étant compris entre 1,5 et 3,5 et B étant compris entre H/2 et H/10 et C étant compris entre H/2 et H/5.

2. Moteur à ultrasons selon la revendication 1, **caractérisé en ce que** l'actionneur ultrasonique (1) prend la forme d'un segment d'une bague (5) pour l'essentiel ronde ou elliptique ou parabolique.

3. Moteur à ultrasons selon la revendication 1, **caractérisé en ce que** l'actionneur ultrasonique (1) prend la forme d'un segment de bague (5) anguleuse.

4. Moteur à ultrasons selon la revendication 1, **caractérisé en ce que** l'actionneur ultrasonique (1) comporte deux surfaces latérales (7, 8) incurvées et que les deux surfaces latérales (7, 8) incurvées sont reliées l'une à l'autre via les surfaces frontales (21) et deux surfaces planes latérales (6).

5. Moteur à ultrasons selon au moins l'une quelconque des revendications précédentes, **caractérisé en ce que** celui-ci comporte deux actionneurs ultrasoniques (1, 82) se croisant.

6. Moteur à ultrasons selon au moins l'une quelconque des revendications précédentes, **caractérisé en ce que** le générateur (35, 36) de l'onde stationnaire bidimensionnelle asymétrique comporte une céramique piézoélectrique (40) à une ou plusieurs couches.

7. Moteur à ultrasons selon au moins l'une quelconque des revendications précédentes, **caractérisé en ce que** les éléments de frottement (2) présentent une surface de frottement (43) plane et/ou convexe et/ou concave et/ou côtelée.

8. Moteur à ultrasons selon au moins l'une quelconque des revendications précédentes, **caractérisé en ce que** l'élément (4) à frotter prend la forme d'une tige ou d'une plaque ou d'une bague ou d'un disque ou d'une partie d'une bague ou d'une partie d'un disque et comporte respectivement une structure à une ou plusieurs couches.

9. Moteur à ultrasons selon au moins l'une quelconque des revendications précédentes, **caractérisé en ce que** l'élément (4) à frotter prend la forme d'un disque et est disposé au travers d'un élément de palier, de préférence un palier de roulement (23).

10. Moteur à ultrasons selon au moins l'une quelconque des revendications précédentes, **caractérisé en ce que** l'élément (4) à frotter est maintenu par des actionneurs ultrasoniques (1) disposés de façon opposée ou décalée les uns par rapport aux autres.

11. Moteur à ultrasons selon au moins l'une quelconque des revendications précédentes, **caractérisé en ce que** l'élément (4) à frotter est maintenu par au moins un élément élastique disposé sur au moins une des surfaces (9) de l'actionneur ultrasonique (1), de préférence par un élément à ressort (73).

12. Moteur à ultrasons selon au moins l'une quelconque des revendications précédentes, **caractérisé en ce que** le dispositif d'excitation électrique (89) comprend un générateur (90) de tension alternative électrique et que le générateur (90) se compose d'un amplificateur de puissance (104), d'un dispositif de formation du signal d'excitation (105) et d'un circuit de retour (106) formant un circuit fermé maintenant la fréquence de la tension électrique de l'actionneur excité identique à la fréquence de résonance de l'onde stationnaire ultrasonique bidimensionnelle asymétrique produite dans l'actionneur ou proche de celle-ci.

13. Moteur à ultrasons selon au moins l'une quelconque des revendications précédentes, **caractérisé en ce que** le dispositif d'excitation électrique (89) comporte un dispositif de réajustement de l'amplitude (125) de l'actionneur ultrasonique excité.

14. Moteur à ultrasons selon au moins l'une quelconque des revendications précédentes, **caractérisé en ce que** le dispositif de réajustement de l'amplitude (125) prend la forme d'un amplificateur de puissance analogique.

15. Moteur à ultrasons selon au moins l'une quelconque des revendications précédentes, **caractérisé en ce que** le dispositif de réajustement de l'amplitude (125) prend la forme d'un système de commande PWM (129).

16. Moteur à ultrasons selon au moins l'une quelconque des revendications précédentes, **caractérisé en ce que** l'amplificateur de puissance (104) du dispositif d'excitation électrique (89) de l'actionneur ultrasonique (1) prend la forme d'un amplificateur linéaire et que le dispositif de réajustement de l'amplitude (125) prend la forme d'un synthétiseur programmable de tension électrique de type sinusoïdale ou quasi sinusoïdale.

17. Moteur à ultrasons selon au moins l'une quelconque des revendications précédentes, **caractérisé en ce que** l'amplificateur de puissance (104) du dispositif d'excitation électrique (89) de l'actionneur ultrasonique (1) prend la forme d'un amplificateur de puissance D et que le dispositif de réajustement de l'amplitude (125) prend la forme d'un modulateur PWM.

18. Moteur à ultrasons selon au moins l'une quelconque des revendications précédentes, **caractérisé en ce que** l'amplificateur de puissance (104) du dispositif d'excitation électrique (89) de l'actionneur ultrasonique prend la forme d'un amplificateur de puissance D et que le dispositif de réajustement de l'amplitude (125) prend la forme d'un modulateur sigma-delta.

19. Moteur à ultrasons selon au moins l'une quelconque des revendications précédentes, **caractérisé en ce que** l'élément (4) à frotter est pourvu d'un capteur de position (140) et que le dispositif d'excitation électrique (89) est pourvu d'un dispositif de réajustement guidé par processeur pour la position ou la vitesse de déplacement prédéfinies de l'élément (4) à frotter.
